# EUROPEAN PATENT SPECIFICATION

(11) **EP 0 439 154 B1**
(45) Date of publication and mention of the grant of the patent: **24.04.1996**
(21) Application number: 91100848.0
(22) Date of filing: 23.01.1991
(51) Int. Cl.: G11C 8/00, G11C 5/14, G11C 11/415, G11C 11/419, G11C 11/418

(54) **Semiconductor memory device and data processing device using same**
Halbleiterspeicheranordnung und Datenverarbeitungsanordnung und deren Verwendung
Dispositif de mémoire à semi-conducteurs et dispositif de traitement de données l'utilisant

(30) Priority: 24.01.1990 JP 14102/90; 24.01.1990 JP 14103/90; 26.01.1990 JP 17041/90; 26.01.1990 JP 17042/90; 23.05.1990 JP 133226/90; 18.06.1990 JP 159414/90; 14.01.1991 JP 2406/91
(43) Date of publication of application: 31.07.1991
(73) Proprietor: SEIKO EPSON CORPORATION, Shinjuku-ku Tokyo-to (JP)
(72) Inventor: Kayamoto, Hiroshi, c/o Seiko Epson Corporation, Suwa-shi, Nagano-ken (JP); Nakajima, Masahiko, c/o Seiko Epson Corporation, Suwa-shi, Nagano-ken (JP)
(74) Representative: Hoffmann, Eckart, Dipl.-Ing.

(56) References cited:
- EP-A- 0 090 632
- GB-A- 2 028 046
- US-A- 4 536 859
- PATENT ABSTRACTS OF JAPAN vol. 11, no. 274 (P-612)5 September 1987

## Description

The invention relates to a static type semiconductor memory device and a data processing device using same, and more particularly to improved peripheral circuits in a static RAM (SRAM) with memory cells or flip-flop circuits.

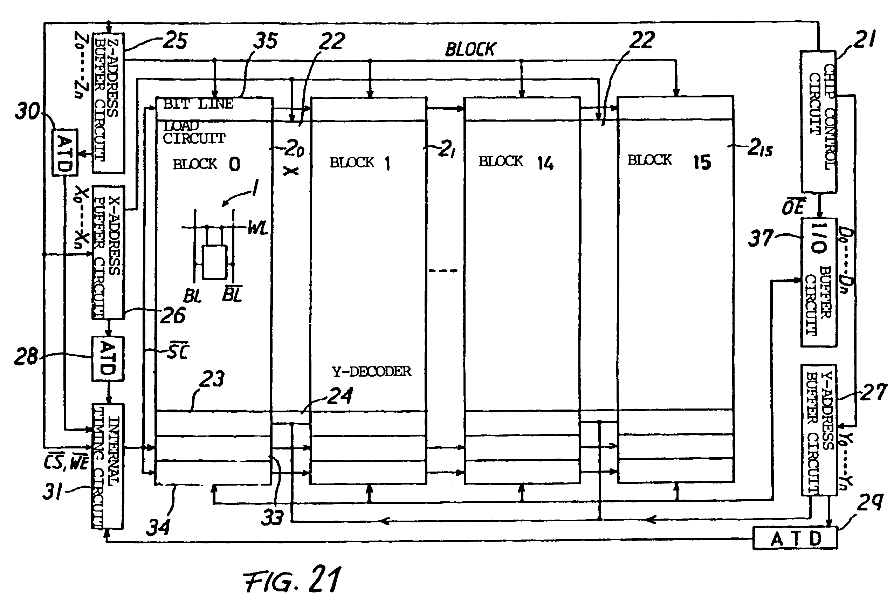

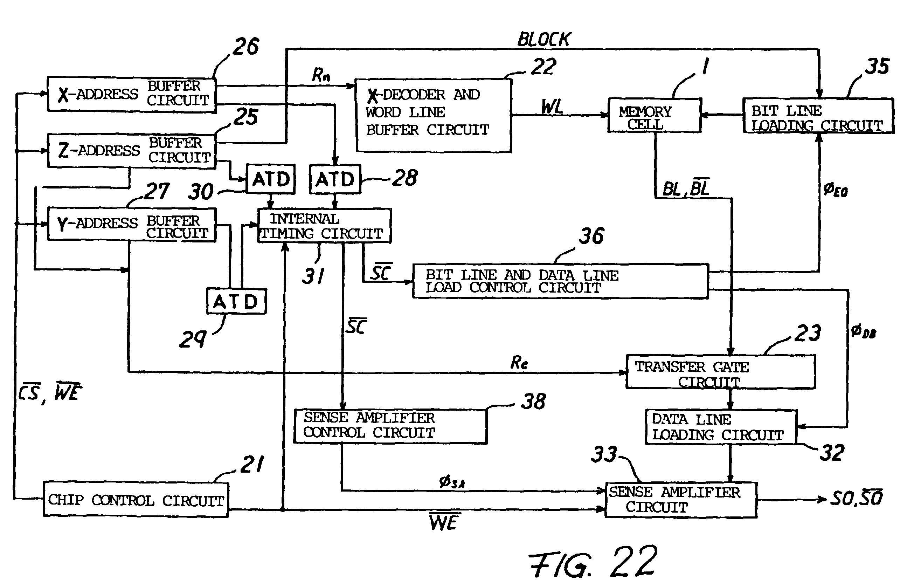

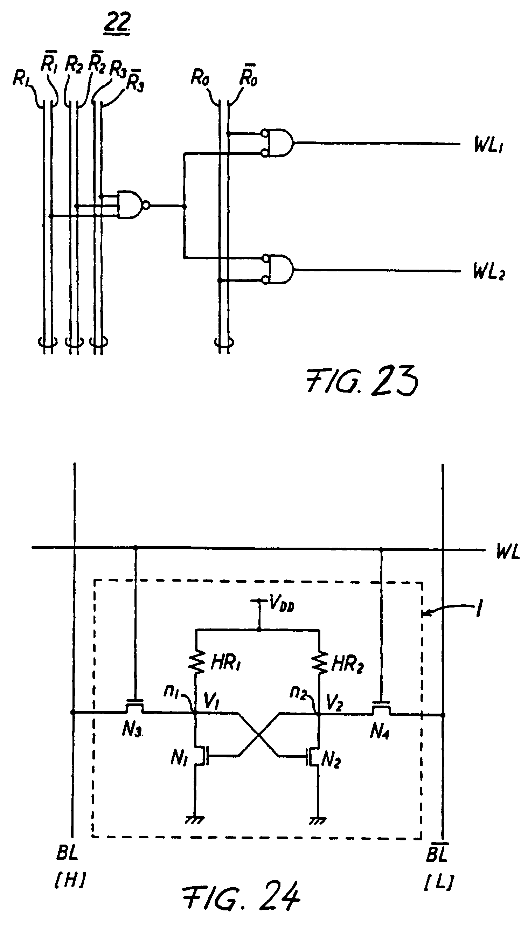

A typical high resistance type static RAM (SRAM) which adopts an internal synchronous mechanism is constituted as shown in Fig. 21. The SRAM has memory cell arrays (blocks) 2₀∼2₁₅ formed by arranging a plurality of polysilicon memory cells 1 of the high resistance type in matrix form, and a peripheral circuit which performs writing and reading operations wherein one or more memory cells are selected and data or information is written into or read from the selected cells. The peripheral circuit shown in Figs. 21 and 22 is generally constituted by a chip control circuit 21 which supplies a chip selecting signal $\overline{\text{CS}}$, write enable signal $\overline{\text{WE}}$ and output enable signal $\overline{\text{OE}}$ to prescribed circuits on a chip on the basis of control signals provided from the outside, an X-decoder and word line buffer circuit 22 for selecting word lines, an Y-decoder 24 for selecting transfer gate circuits 23, a Z-address buffer circuit (block signal generator) 25 which generates a block signal BLOCK for selecting one or more blocks 2₈∼2₁₅₉, an X-address buffer circuit 26 for sending information to the X-decoder 22, an Y-address buffer circuit 27 for sending information to the Y-decoder 24, address-transition detecting circuits (ATDs) 28, 29 and 30 which detect transition of the address input signals of the X, Y and Z-address buffer circuits and generate pulses, an internal timing circuit 31 for generating synchronizing signals in order to precharge and equalize bit lines BL, $\overline{\text{BL}}$ just before reading out in a manner to utilize basic pulses generated from the ATDs, a data line load circuit 32 which controls the potentials of data lines when writing and reading, a sense amplifier circuit 33 for producing amplified outputs SO, $\overline{\text{SO}}$ and for detecting small voltages SIN, $\overline{\text{SIN}}$ emerged on the data line through the transfer gate circuit 23 from memory cells when reading, a writing driver circuit 34 which sends data for writing to the bit line BL, $\overline{\text{BL}}$ when writing, a bit line load circuit 35 which controls load of the bit lines BL, $\overline{\text{BL}}$ when writing and reading and for equalizing the bit lines BL, $\overline{\text{BL}}$ so as to have the same potential just before reading, a bit/data line load control circuit 36 for controlling the bit line load circuit 35 and data line load circuit 32, an I/O buffer circuit 37, and a sense amplifier control circuit 38 for generating a sense amplifier control pulse Φ_{SA} which drives the sense amplifier circuit 33 dynamically according to a signal supplied from the internal timing circuit 31. The X-decoder and word line buffer circuit 22 is conventionally constituted as shown in Fig. 23, wherein it comprises a NAND gate having three inputs for receiving buffer outputs R1-R3 or $\overline{\text{R1}}$-$\overline{\text{R3}}$ from the X-address buffer circuit 26, and a NOR gate having two inputs for receiving an output of the NAND gate and a buffer output Ro or $\overline{\text{Ro}}$ from the X-address buffer circuit 26. According to the circuit 22, a selected word line WL (WL1, WL2 and the like) is set to a supplied potential V_{DD} of high level (hereinafter referred to as "H"). To the word lines WL are connected memory cells 1 as shown in Fig. 24. To the memory cells 1 connected with a selected word line WL, data writing or reading is carried out via the bit lines BL, $\overline{\text{BL}}$.

The potential of the selected word line WL is set to be the supplied potential V_{DD} of high level "H", that is, of logically high level by means of logic circuits comprising the X-decoder and word line buffer circuit 22. Consideration is made to the case that data writing is carried out by setting the bit line BL to be "H" and setting the bit line $\overline{\text{BL}}$ to be low level potential or the ground potential (hereinafter referred to as "L"). Potential of the memory nodes n1, n2 in the memory cell 1 is established as follows. Since the potential Vw1 of the word line WL is set to be the supplied potential V_{DD}, the maximum potential of the memory node n1 is defined by the following expression.${\text{V1=Vw1-Vt1-Vb=V}}_{\text{DD}} \text{-Vt1-Vb}$ wherein V_{DD} is a supplied potential, Vt1 is a threshold voltage of n-channel MOS transistors N3, N4 acting as transfer gates, and Vb is a voltage drop component resulting from a backgate effect. The memory nodes n1, n2 in the memory cell 1 are connected to the supplied potential V_{DD} through the polysilicon high resistance resistors HR1, HR2, respectively. The values of these polysilicon resistors HR1, HR2 are generally set to be in the range of some hundred giga-ohms to a few tera-ohms in order to limit current flow to the nodes during the waiting period (stationary period). The currents through the resistors HR1, HR2 are very small, so that the maximum potential of the memory node n1 during writing operation, which is obtained from the expression (1), is not likely to rise as high as the supplied potential V_{DD}. If the polysilicon resistors HR1, HR2 are set to have smaller values in order to obtain the pull-up effect, the current consumption increases during a non-operating condition. The condition of$\text{V1>Vt2}$ must be satisfied to hold data in the flip-flop of the memory cell 1, wherein the maximum potential V1 is given by the expression (1), and Vt2 is a threshold voltage of the n-channel MOS transistors N1, N2. Thus, when data writing, it is necessary to satisfy the following condition obtained by substituting the expression (1) into the expression (2).${\text{Vw1-Vt1-Vb=V}}_{\text{DD}} \text{-Vt1-Vb>Vt2}$

If writing operation is carried out under the condition that the expression (3) is not satisfied, both of the n-channel MOS transistors N1 and N2 in the flip-flop become off-state and therefore will not be able to hold data of the memory cell 1. In this non-operating state wherein the memory cell 1 does not function as a flip-flop, when noise comes into the memory cell 1 or reading operation begins erroneously, the data in the memory cell 1 are easily destroyed.

According to the semiconductor technology, it is necessary to satisfy V_{DD} > 2.4 V on the assumption that Vt1=Vt2=0.9V, Vb = 0.6 V. This means that the SRAM of the prior art cannot be written or read properly unless the supplied voltage V_{DD} is higher than 2.4 V.

In table calculator applications commonly requiring an electric battery as a power source, the power source voltage is 3 V for example. However, the voltage value of the battery drops according to its lifetime. The SRAM of the prior art is driven in the calculator by the 3 V-battery and so the battery will need to be frequently changed because the SRAM will not work after the voltage drop becomes more than 0.6 V.

On the other hand, there is known a fully CMOS type memory cell in which p-channel MOS transistors are used instead of polysilicon high resistance resistors HR1, HR2, and a SRAM constituted by the fully CMOS type memory cells is driven by a low supply voltage. However, this type of memory cell tends to increase the size thereof because it must be provided with an isolation region for device isolation between an n-channel MOS transistor and a p-channel MOS transistor as known in the semiconductor technology. In contrast, memory cells of high resistance type have the benefit of decrease in cell size since it is possible to form a 3-dimensional structure with polysilicon high resistance resistors on an insulation film covering the n-channel MOS transistor. However, the SRAM equipped with memory cells of the high resistance type has the problem that it cannot be operated by using a low voltage power supply as mentioned above.

Consequently, two methods are proposed in order to satisfy the expression (3) in use of a low voltage power supply in a manner that memory cells of the high resistance type can be operated properly. One of them is to lower the threshold voltages Vt1, Vt2, and the other to decrease the voltage drop Vb caused by the backgate effect. To decrease the threshold voltages Vt1, Vt2 causes the complication of process conditions and the deterioration of the memory cells's own stability under changing the threshold voltage of n-channel MOS transistors N1, N2, N3 and N4. Hence this method is not practical. The decrease of the voltage Vb during writing operation is not practical, either. Because the substrate capacity of the memory cell is large, the method induces an increase in the electricity consumption by adding control circuits.

A semiconductor memory device according to the precharacterizing portion of claim 1 is disclosed in EP-A-0 090 632.

It is an object of the present invention to provide a semiconductor memory device and a data processing device using it which is constructed as an SRAM in which memory cells having load resistors of high resistance, load MOS elements or thin film type load means are formed and which is not the fully CMOS type memory cell.

This object is achieved with a semiconductor memory device and a data processing device, respectively, as claimed.

According to the invention, the size of a memory part can be reduced, the electric power consumption can be decreased and the writing operation can be performed by a simple battery of low voltage power supply.

In accordance with the present invention, there is provided a semiconductor memory device having at least one memory cell. The memory cell comprises a flip-flop which includes two circuits, each connected between a first supplied potential (for example, high level potential) and a second supplied potential (for example, low level potential), respectively. One of the circuits is constituted by a first load means (for example, a polysilicon high resistance resistor, a load MOS element, a thin film transistor, and the like) and a first insulated gate field effect transistor serially connected to the first load means, while the other circuit is constituted by a second load means (for example, a polysilicon high resistance resistor, a load MOS element, a thin film transistor, and the like) and a second insulated gate field effect transistor serially connected to the second load means. The memory cell also has insulated gate field effect transistors for access to the flip-flop which are connected between a memory node of the flip-flop and a bit line and which have gate inputs for receiving the potential on a word line. The memory device of the present invention is characterized by that it has a word line potential transformation means which controls the word line potential during the writing operation to be a writing potential. The value of the writing potential is higher than both of the supplied potentials. The word line potential transformation means is provided with repeating means which repeats to change a potential up and down alternately in a manner that the lower-side potential is controlled to fall between the supplied potentials, whereas the upper-side potential is to be the same as the writing potential. The word line potential transformation means is also provided with a multiple-stage step-up means which generates the writing potential. A preferred embodiment of the the word line potential transformation means has a pulse generating means, a deviation timing signal generating means, a stepped-up potential generating means, a voltage step-up control signal generating means, a word line supplied potential synthesizing means, and a word line potential supply control means. The pulse generating means repeats to output pulses during the data writing operation. On the basis of the generated pulses, the deviation timing signal generating means generates a plurality of prescribed timing signals. The stepped-up potential generating means generates a stepped-up potential which is higher than the supplied potential of high level in accordance with the prescribed timing signal. The voltage step-up control signal generating means produces a step-up control signal on the basis of the prescribed timing signal. The level of control signal is set to be higher than that of the supplied potential of the higher side. The word line supplied potential synthesizing means selectively synthesizes the stepped-up potential provided from the stepped-up potential generating means and the high level potential from the power supply on the basis of the step-up control signal, so that it produces the word line supplied potential in the form of serial pulses. The word line potential supply control means controls the supply of the word line supplied potential to the word line on the basis of the prescribed timing signal and the step-up control signal. In order to perform the step-up operation of the word line potential during the reading operation, improved peripheral circuitry is provided according to the present invention, which produces the potential of the data line. More specifically, the peripheral circuitry has a potential setting detection means for detecting a point when a selected word line is set to be the writing potential during the reading operation, and a sense amplifier control means which sends out a sense amplifier control signal for activating the sense amplifier means on the basis of the output of the potential setting detection means.

According to the above arrangement of the present invention, the word line potential is set to be the stepped-up potential which is higher than the supplied potential by means of the word line potential transformation means. The stepped-up potential is applied to the gate of the insulated gate field effect transistors for access to the flip-flop in the memory cell. Where the potential of the bit line is "H", the writing potential is transferred via the transistor to the memory nodes of the memory cell, the value of the writing potential being the difference between the stepped-up potential and a threshold voltage (including the voltage drop by the backgate effect). In case the difference in potential is larger than the threshold voltage of the insulated gate field effect transistor of the flip-flop, the proper writing operation is carried out. Thus, according to the present invention, even if a power supply of low output voltage is utilized, the writing operation can be carried out without any trouble because the gate is applied with the stepped-up potential higher than the supplied potential. In other words, the present invention enables to use a low voltage power supply, and furthermore to reduce the number of the batteries required to activate the transistor.

It is possible to maintain the potential of a selected word line to be a stepped-up potential during the writing period. It is, however, preferable to provide the repeating means repeating up and down operation of the potential between the stepped-up voltage and the low level supplied potential during data writing operation. With the repeating means, it can be realized that the data writing is carried out in a multiple-check manner to write the same data repeatedly, whereby erroneous data writing can be avoided. Where the word line potential transformation means is provided with the multiple-state step-up means which generates the stepped-up potential obtained by multiple stages of the stepping-up operation, the stepped-up potential can surely be held high enough.

As described above, according to the present invention, the word line is supplied with the stepped-up potential by the word line potential transformation means instead of the supplied potential. However, a time-lag is produced between the start of supplying potential and finishing the setting of the word line to the prescribed stepped-up potential. According to a preferred embodiment, in order to avoid the time lag, the peripheral circuit related to the data line is constituted by the potential setting detection means to detect when the word lines are set to the writing potential during the reading operation, and the sense amplifier control means which sends the sense amplifier control signal to the sense amplifier means on the basis of the output of the potential setting detection means. The circuit configuration makes it possible to eliminate a period for relaxation of amplified potential of the inversion data which emerges on the data line by a noise in the step-up operation, since the sense amplifier is activated after setting the potential of the word line to a prescribed value. Therefore, the sense amplifier cannot amplify the data. Hence it becomes easy to avoid a reading error and to adjust the timing of various signals of the circuits connected to the sense amplifier.

An embodiment of the invention will be described below with reference to drawings in which:
- Fig. 1: is a block diagram showing the whole constitution of the static RAM equipped with polysilicon memory cells of the high resistance type of a preferred embodiment according to the present invention;
- Fig. 2: is a block diagram showing a portion of the peripheral circuits in the semiconductor memory device of Fig. 1, the portion relating mainly to the writing operation;
- Fig. 3: illustrates a ring-oscillator circuit and a deviation timing signal generating circuit of the peripheral circuit of Fig. 2;
- Fig. 4: illustrates in detail a ring-oscillator in the ring-oscillator circuit of Fig. 3;
- Fig. 5: illustrates in detail a step-up gate control signal generating circuit in the peripheral circuit of Fig. 2;
- Fig. 6: illustrates in detail a stepped-up potential generating circuit in the peripheral circuit of Fig. 2;
- Fig. 7: illustrates in detail a word line supplied potential mixing circuit in the peripheral circuit of Fig. 2;
- Fig. 8: illustrates in detail an X-decoder and a word line buffer circuit, and a word line potential supplying control circuit in the peripheral circuit of Fig. 2;
- Fig. 9: illustrates in detail a step-up detecting circuit in the peripheral circuit of Fig. 2;
- Fig. 10: illustrates in detail a sense amplifier control circuit in the peripheral circuit of Fig. 2;
- Fig. 11: illustrates in detail a bit/data line load control circuit in the peripheral circuit of Fig. 2;
- Fig. 12: illustrates in detail a bit line load circuit and a data line load circuit in the peripheral circuit of Fig. 2;
- Fig. 13: is a timing chart showing signals in the ring-oscillator circuit and the timing signal generating circuit of Fig. 3;
- Fig. 14: is a timing chart showing signals in the step-up gate control signal generating circuit of Fig. 5;
- Fig. 15: is a timing chart showing signals in the stepped-up potential generating circuit of Fig. 6;
- Fig. 16: is a timing chart showing signals in the word line supplied potential mixing circuit of Fig. 7;
- Fig. 17: is a timing chart showing signals in the word line potential supplying control circuit of Fig. 8;
- Fig. 18: is a timing chart showing signals in a portion of the circuit relating to reading operation for explanation of problems due to noise during reading in the device of Fig.1;
- Fig. 19: is a timing chart showing signals in an improved portion of circuits relating to reading operation for explanation of problems due to noise during reading in the device of Fig. 1;
- Fig. 20: is a block diagram showing the constitution of the electronic memo pad application including the device of Fig. 1;
- Fig. 21: is a block diagram showing a typical constitution of a static RAM;
- Fig. 22: is a block diagram showing the peripheral circuit in a static RAM of the prior art;
- Fig. 23: illustrates in detail an X-decoder and a word line buffer circuit of the prior art of Fig. 22; and
- Fig. 24: illustrates a memory cell of the high resistance type in the static RAM of Fig. 22.

The invention will now be explained in detail with reference to the attached drawings.

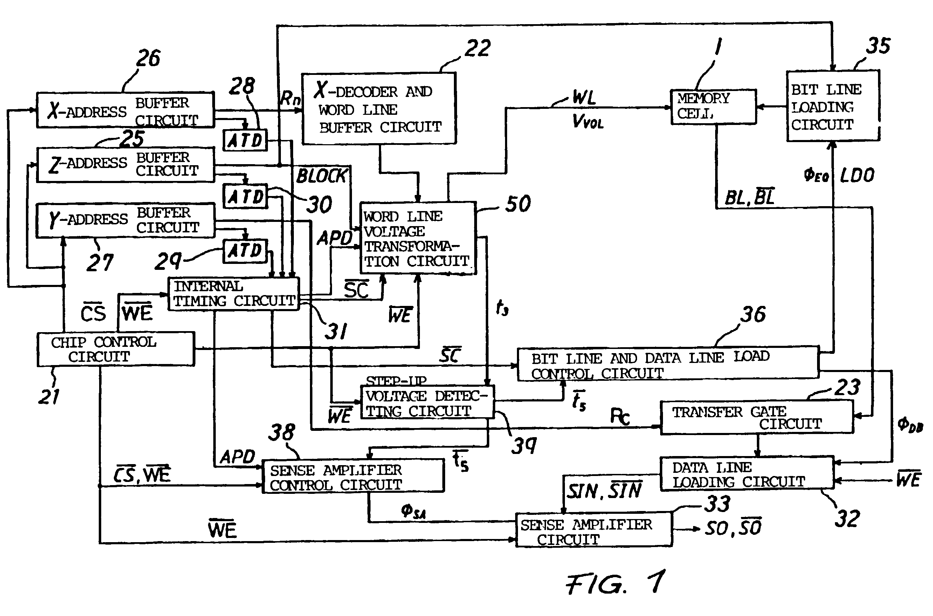

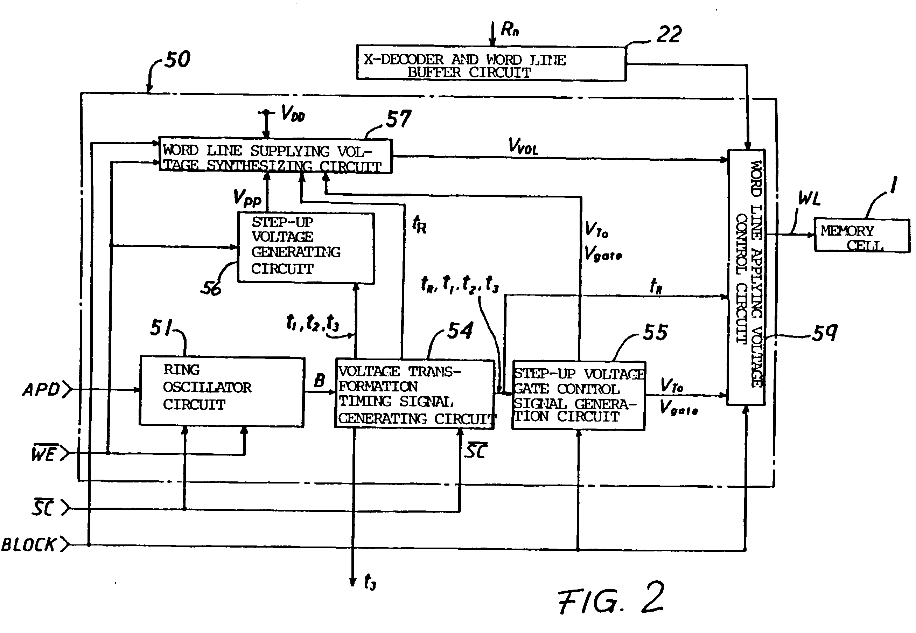

Fig. 1 is a block diagram of an embodiment of the present invention, wherein circuits of an SRAM having a monolithic polysilicon memory cell of high load type are generally illustrated. Fig. 2 is a block diagram which illustrates circuit portions relating mainly to the SRAM for writing operations. The components shown in Fig. 1 corresponding to those of Fig. 22 are designated by the same numerals, so that these components will not be explained in the following.

For this embodiment, the word line pulse-driving method is adopted. When a certain word line WL is selected, in order to reduce an amount of current flowing into a memory cell 1, an internal timing or synchronizing circuit 31 generates an automatic power down signal APD according to basic pulses generated by address-transition detection circuits (ATD) 28, 29 and 30, and thereby the word line WL is operated by a pulse-driving method during a predetermined period of time. A chip control circuit 21 generates a system control signal $\overline{\text{CS}}$, a write enable signal $\overline{\text{WE}}$ and an output enable signal $\overline{\text{OE}}$. One aspect newly provided for this embodiment, is that a word line voltage transformation circuit 50 is provided to maintain the value of potential on the word line WL to be higher than that of the power source voltage V_{DD} when the word line is selected for writing operation. An internal arrangement of the word line voltage transformation circuit 50 is shown in Fig. 2. This transformation circuit 50 is constituted by a ring oscillator circuit 51, a voltage transformation timing signal generating circuit 54, a step-up voltage gate control signal generating circuit 55, a step-up voltage generating circuit 56, a word line supplying voltage synthesizing circuit 57 and a word line applying voltage control circuit 59.

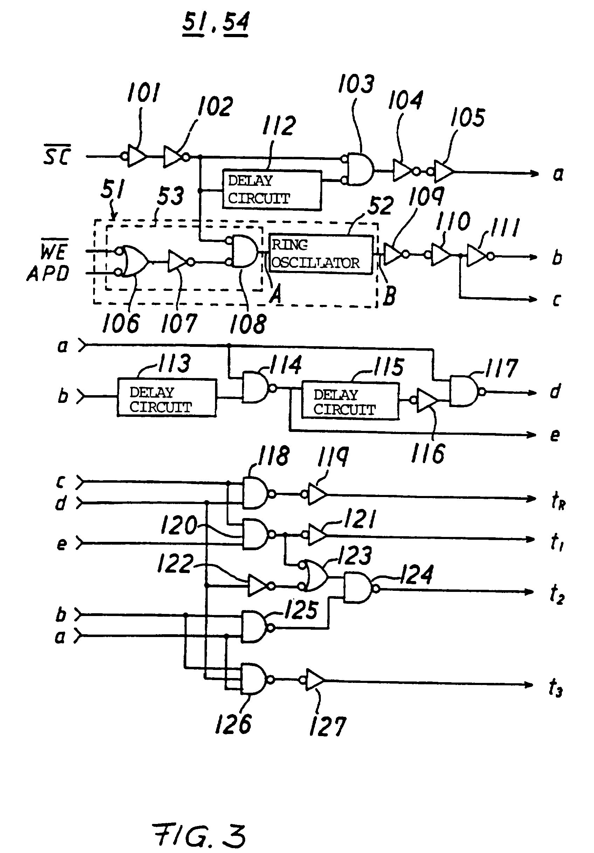

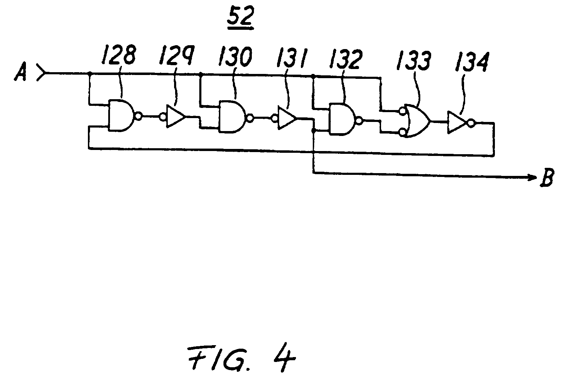

The ring oscillator circuit 51 generates recurring pulses based on the system control signal $\overline{\text{SC}}$ of the internal timing circuit 31. As shown in Fig. 3, the ring oscillator circuit 51 is constituted by a ring oscillator 52 and a selective driving circuit 53. The selective driving circuit 53 activates the oscillator 52 selectively based on the input of the automatic power down signal ADP, the write enable signal $\overline{\text{WE}}$ and the system control signal $\overline{\text{SC}}$. The ring oscillator 52 is, as shown in Fig. 4, constituted by connecting a plurality of logic circuits 128-134 in the form of a loop, and generates recurring pulses B as long as an output A ("H") is supplied from the selective driving circuit 53.

The voltage transformation timing signal generating circuit 54 is shown in Fig. 3. The generating circuit 54 has logic circuits 101-105, 109-111, 114, 116-127 and delay circuits 112, 113, 115, and produces preset timing signals t_{R}, t₁, t₂ and t₃, each of which has substantially a pulse amplitude corresponding to the power source voltage V_{DD}. These signals are generated in accordance with the recurring pulses B sent out from the ring oscillator circuit 51 when the system control signal $\overline{\text{SC}}$ is applied.

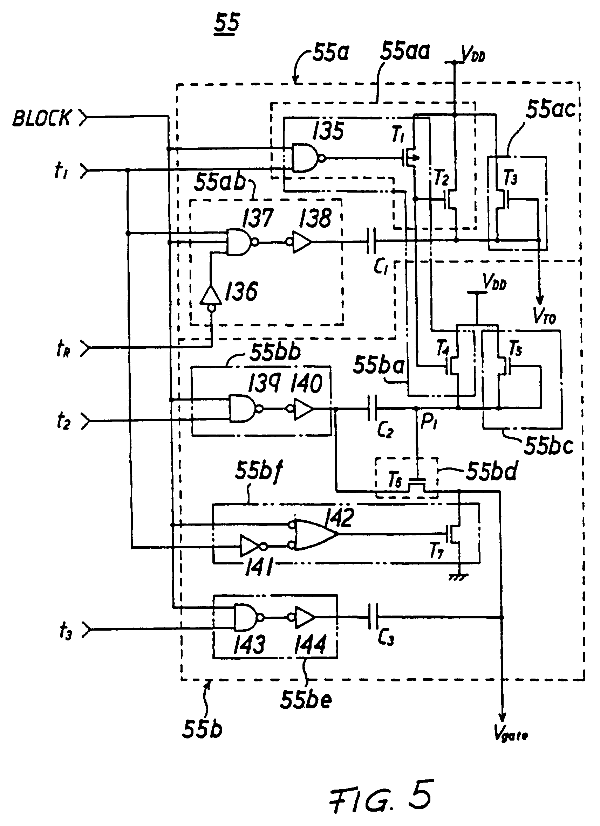

Based on the timing signals t_{R}, t₁, t₂, t₃ and a block signal BLOCK, the step-up voltage gate control signal generating circuit 55 generates step-up voltage gate control signals V_{TO} and Vgate, and thereby a gate of a pre-selected MOS transistor in the word line voltage transformation circuit 50 is driven selectively. The circuit arrangement of the control signal generating circuit 55 is shown in Fig. 5. The signal generating circuit 55 has a first step-up voltage gate control signal generating circuit 55a which generates the step-up voltage gate control signal V_{TO}, and a second step-up voltage gate control signal generating circuit 55b which generates the step-up voltage gate control signal Vgate.

The first step-up voltage gate control signal generating circuit 55a is constituted by a charge injection circuit 55aa which charges a voltage step-up capacitor C1 based on the timing signal t1 and the block signal BLOCK, a potential applying circuit 55ab which increases a voltage appearing on the negative electrode of the capacitor C1 when it receives the block signal BLOCK and timing signals t_{R} and t₁, and a limiting circuit 55ac which controls the value of the step-up voltage gate control signal V_{TO} so as not be higher than the required voltage value. One of the electrodes of the capacitor C1 is formed by a first layer of polysilicon by which a gate electrode (or gate electrodes) of a MOS transistor(s) is also formed. The other electrode of the capacitor C1 is formed by a second polysilicon layer via an insulating layer. The second layer is of high resistance polysilicon. The second step-up voltage gate control signal generating circuit 55b has a first step charge injection circuit 55ba, a part of which is common to that of the first control signal generating circuit 55a and that of the charge injection circuit 55aa, and which charges a first voltage step-up capacitor C2 when it receives the timing signal t₁ and the block signal BLOCK. The circuit 55b also has a first step potential applying circuit 55bb which increases the potential appearing on the negative electrode of the capacitor C2 when it receives the timing signal t₂ and the block signal BLOCK, a potential transfer circuit 55bd which sends out the potential appearing on the negative electrode of the capacitor C2, a limiting circuit 55bc which protects a MOS transistor T6 in the potential transfer circuit 55bd from a damage while the potential is raised, a second step potential applying circuit 55be which raises the potential appearing on the negative electrode of a second voltage step-up capacitor C3 when it receives the block signal BLOCK and the timing signal t₃, and a discharging circuit 55bf which discharges the capacitor C3 according to the block signal BLOCK and the timing signal t₁. The first step charge injection circuit 55ba, the voltage step-up capacitor C2, the potential applying circuit 55bb and the limiting circuit 55bc constitute a charging circuit for the second voltage step-up capacitor C3. One of the electrodes of each of the step-up capacitors C2 and C3 is formed by the first layer of polysilicon by which a gate electrode (or gate electrodes) is also formed. The other electrodes of the capacitors are formed by the second polysilicon layer via an insulating layer. This second layer is of a high resistance polysilicon.

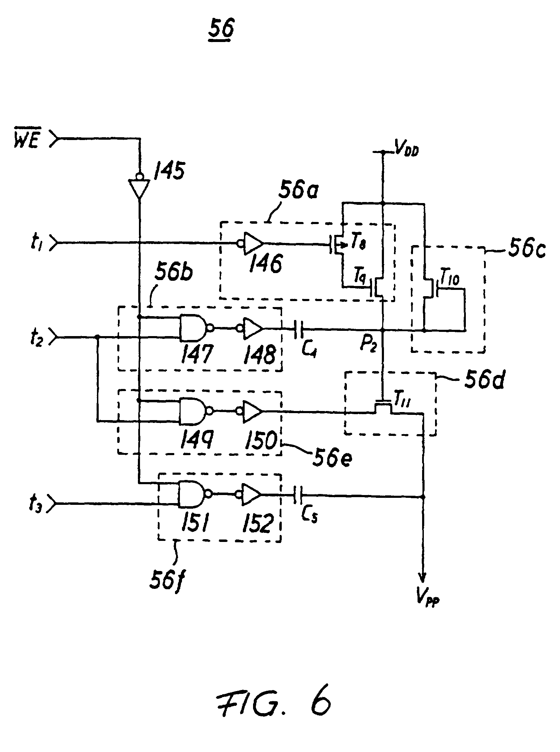

The step-up voltage generating circuit 56 generates a step-up voltage Vpp on the basis of the power source voltage V_{DD} when it receives the timing signals t₁, t₂, t₃ and the write enable signal $\overline{\text{WE}}$. The value of the voltage Vpp is higher than that of the power source voltage V_{DD}. A circuit arrangement of this generating circuit 56 is shown in Fig. 6. The generating circuit 56 is constituted by a first step charge injection circuit 56a for charging a first voltage step-up capacitor C4 when it receives the timing signal t₁, a first step potential applying circuit 56b for raising the potential of the negative electrode of the capacitor C4 when it receives the write enable signal $\overline{\text{WE}}$ and the timing signal t₂, a potential transfer circuit 56d, a limiting circuit 56c for protecting a MOS transistor T11 in the potential transfer circuit 56d from damage during the voltage increasing operation, a voltage applying circuit 56e which applies the power source voltage V_{DD} to the potential transfer circuit 56d when it receives the write enable signal $\overline{\text{WE}}$ and the timing signal t₂, and a second step potential applying circuit 56f for raising the potential of the negative electrode of a voltage step-up capacitor C5. Electrodes of one side of the respective step-up capacitors C4 and C5 are formed by the first layer of polysilicon by which a gate electrode (or gate electrodes) is also formed. The other electrodes of the respective capacitors are formed by the second polysilicon layer via an insulating layer. The second layer is of high resistance polysilicon.

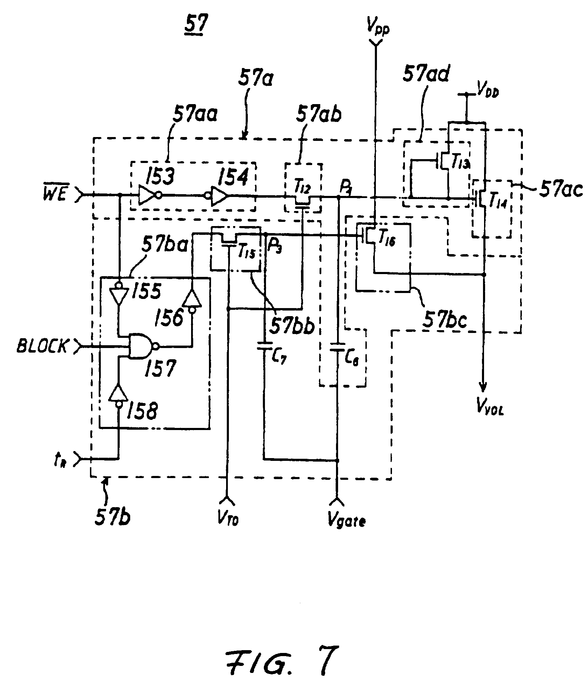

The word line supplying voltage synthesizing circuit 57 produces a word line supplying voltage V_{VOL} on the basis of either the power source voltage V_{DD} or the step-up voltage Vpp in accordance with the write enable signal $\overline{\text{WE}}$, the block signal BLOCK, the timing signal t_{R} and the step-up gate control signals V_{TO}, Vgate. This word line supplying voltage V_{VOL} is supplied to the word line. An arrangement of the word line supplying voltage synthesizing circuit 57 is shown in Fig. 7. This synthesizing circuit 57 has a power source voltage supplying portion 57a and a step-up voltage supplying portion 57b. The power source voltage supplying portion 57a supplies a voltage, the value of which is substantially the same as that of the power source voltage V_{DD}, to the word line applying voltage control circuit 59 during read operation in accordance with the write enable signal $\overline{\text{WE}}$ and the step-up voltage gate control signals V_{TO}, Vgate. The step-up voltage supplying portion 57b supplies intermittently and periodically a potential which is nearly the same as the step-up voltage Vpp during writing operation in accordance with the block signal BLOCK, timing signal t_{R} and step-up voltage gate control signals V_{TO} and Vgate.

The power source voltage supplying portion 57a has a buffer circuit 57aa to which the write enable signal $\overline{\text{WE}}$ is applied, a potential transfer circuit 57ab controlled by the step-up voltage gate control signal V_{TO}, a voltage step-up capacitor C6 whose voltage is increased when it receives the step-up voltage gate control signal Vgate, a potential transfer circuit 57ac controlled by the charged potential of the capacitor C6, and a limiting circuit 57ad for proa MOS transistor T14 in the potential transfer circuit 57ac against a break.

The step-up voltage supplying portion 57b has a logic circuit 57ba which receives the write enable signal $\overline{\text{WE}}$, the block signal BLOCK, and the timing signal t_{R}, a potential transfer circuit 57bb controlled by the step-up voltage gate control signal V_{TO}, a voltage step-up capacitor C7 whose voltage value is increased when it receives the step-up voltage gate control signal Vgate, and a potential transfer circuit 57bc which is controlled by the charged voltage of the capacitor C7. Electrodes of one side of respective step-up capacitors C6 and C7 are formed by the first layer of polysilicon by which a gate electrode (or gate electrodes) is also formed. Electrodes of the other side of these capacitors C6 and C7 are formed by the second polysilicon layer via an insulating layer. This second layer is of high resistance polysilicon.

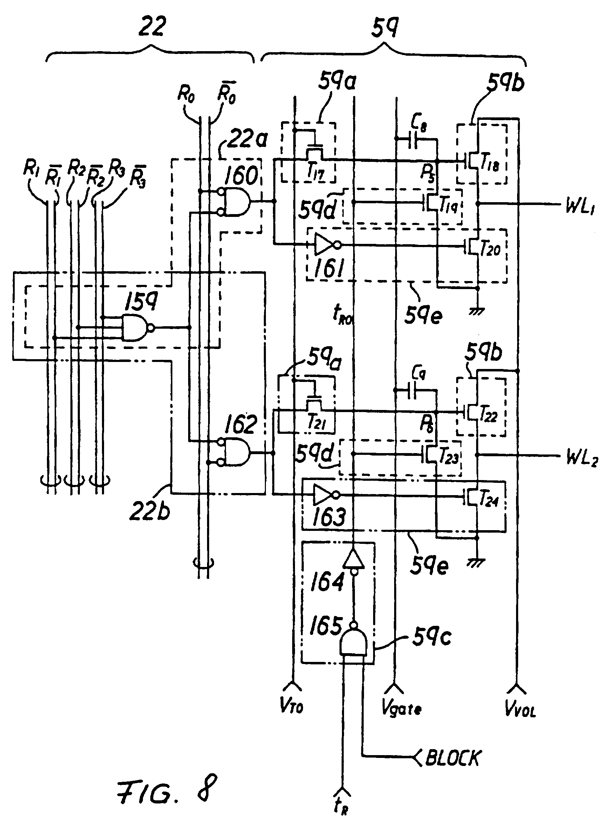

The word line applying voltage control circuit 59 controls the application of the word line supplying voltage V_{VOL} to the word line WL in accordance with the block signal BLOCK, the timing signal t_{R}, the step-up voltage gate control signals V_{TO}, Vgate and an output of the X-decoder and word line buffer circuit 22. As shown in Fig. 8, although the X-decoder and word line buffer circuit 22 is of a conventional type, the word line applying voltage control circuit 59 is additionally provided between the circuit 22 and the memory cell 1. An arrangement of this control circuit 59 is shown in Fig. 8. This control circuit 59 is constituted by a first potential transformation circuit 59a which compensates for a decreased potential value of the output of the X-decoder and word line buffer circuit 22 and then sends out the compensated potential, a voltage step-up capacitor C8 (or C9) whose voltage value is increased when the step-up voltage gate control signal Vgate is applied thereto, a second potential transformation circuit 59b for transforming the word line supplying voltage V_{VOL} in response to the step-up voltage of the aforesaid capacitor C8 (or C9), a discharge timing circuit 59c which generates a discharge timing signal t_{RO} based on the block signal BLOCK and the timing signal t_{R}, a voltage step-up capacitor discharging circuit 59d for discharging the voltage step-up capacitor C8 (or C9) according to the above discharge timing signal t_{RO}, and a word line discharging circuit 59e for discharging electricity appearing on the word line WL rapidly if this word line WL is not selected. Electrodes of one side of step-up capacitor C8 and C9 are formed by the first layer of polysilicon by which a gate electrode (or gate electrodes) is also formed. Electrodes of the other side of these capacitors are formed by the second polysilicon layer via an insulating layer. This second layer is of high resistance polysilicon.

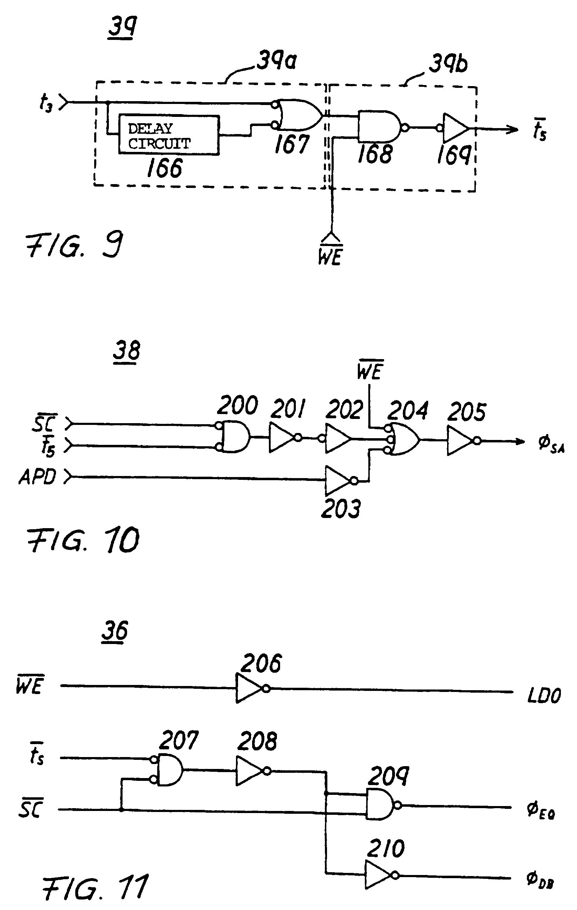

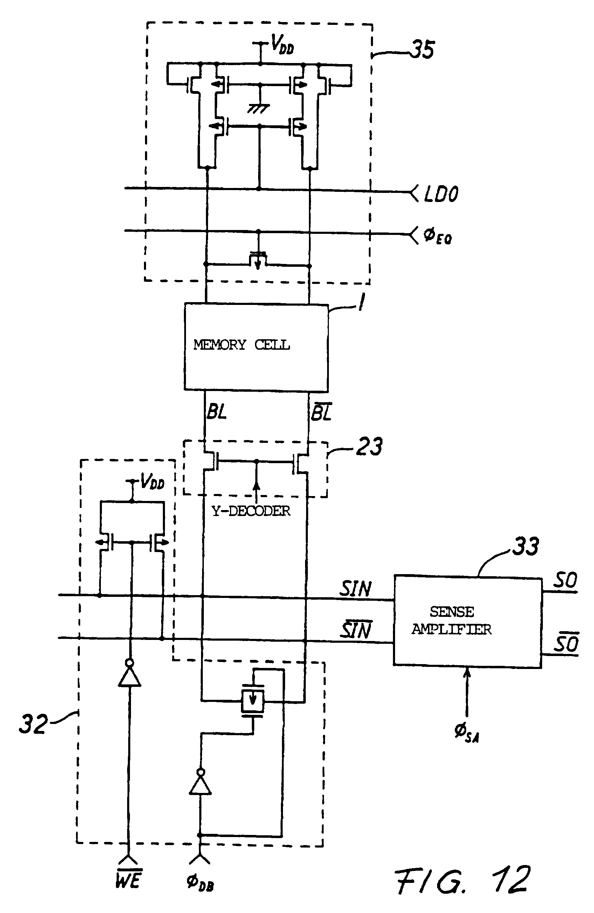

In the present embodiment, there is provided an additional circuit for controlling the read operation. The reason for providing the control circuit will be described later. The voltage step-up detection circuit 39 detects the completion of the voltage step-up operation of the word line WL in accordance with the timing signal t₃ from the word line voltage transformation circuit 50 and the write enable signal $\overline{\text{WE}}$ and in response delivers the timing signal $\overline{\text{t₅}}$ to the sense amplifier control circuit 38 and bit/data line load control circuit 36. As shown in Fig. 9, the voltage step-up detection circuit 39 comprises a delay circuit 39a for delaying the timing signal t₃ by a prescribed delay time, the timing signal t₃ being used for determining the point when the final voltage step-up operation begins, and a timing circuit 39b for producing the timing signal $\overline{\text{t₅}}$ based on the delayed signal and the write enable signal $\overline{\text{WE}}$. The sense amplifier control circuit 38 generates a sense amplifier control signal Φ_{SA} for controlling the state of the sense amplifier 33 on the basis of the system control signal $\overline{\text{SC}}$, timing signal $\overline{\text{t₅}}$, automatic power down signal APD, and write enable signal $\overline{\text{WE}}$. The sense amplifier control circuit 38 is constituted as shown in Fig. 10. The bit-line and data-line load control circuit 36 outputs the bit-line control signal Φ_{EO}, the bit line variable impedance control signal LDO and the data line load control signal Φ_{DB}. The circuit 36 is constituted as shown in Fig. 11. The signals Φ_{EO} and Φ_{DB} are produced in consideration of the timing signal $\overline{\text{t₅}}$ as an output of the voltage step-up detection circuit. The bit-line load circuit 35 and the data-line load circuit 32 may be conventionally constituted, an example of which is shown in Fig. 12.

The writing operation of the present embodiment will now be described. During the writing operation, the write enable signal $\overline{\text{WE}}$ is set to be "L" and the automatic power down signal is also set to be "L". The internal timing circuit 31 outputs the system control signal $\overline{\text{SC}}$ of "L" immediately before the writing operation begins, which causes the selective driving circuit 53 of Fig. 3 to output a logically high signal A. During the period wherein the output A is "H", the ring oscillator 52 outputs pulses B as shown in Fig. 13. The appearance of the output B makes the timing signal generating circuit 54 to generate timing signals t_{R}, t₁ t₂ and t₃. The timing signal t_{R} is of a series of pulses which rise immediately after a respective pulse B drops and which have a pulse width narrower than that of the pulses B. The timing signal t₁ is of a series of pulses which rise when the timing signal t_{R} rises and which have a pulse width narrower than that of the pulses B and wider than that of the timing signal t_{R}. The timing signal t₂ is of a series of pulses which change in their logical level in reverse to the pulses of the timing signal t₁. The remaining timing signal t₃ is also of a series of pulses which go down to a logically low level in response to going down of the timing signal t₂ and which have a pulse width narrower than that of the signal t₂. The ring oscillator as oscillation means is provided in order that the stepped-up potential higher than the source potential is applied to the word lines repeatedly to thereby carry out the write and read operations of data to the memory cell 1 securely.

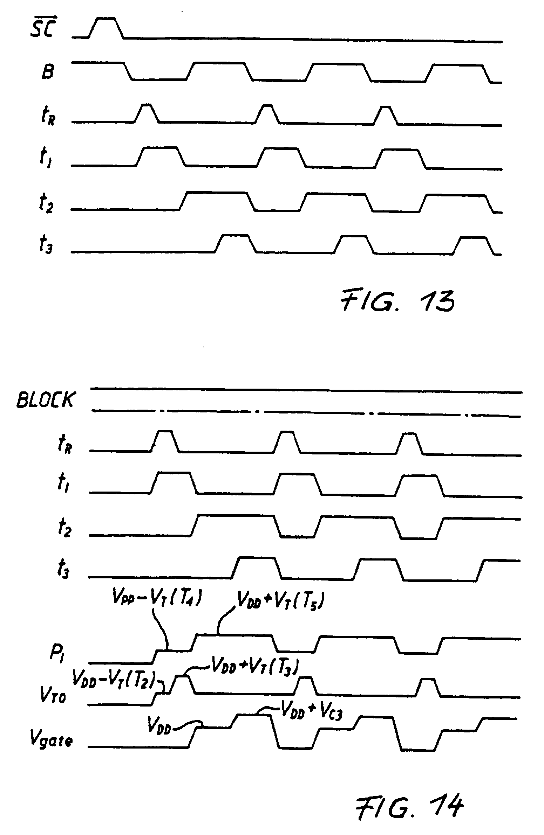

Fig. 14 illustrates signals appearing in the step-up voltage gate control signal generating circuit 55 of Fig. 5. Where a certain block (memory cell array) is in a selected condition, the block signal assigned to the selected block is "H". Where the timing signals t₂ and t₃ are "L", the change in the logical state of the timing signals t_{R} and tₗ from "L" to "H" activates the MOS transistor T1 of the first voltage step-up gate control signal generating circuit 55a. Since the voltage step-up capacitors C1 and C2 are logically low at their negative electrodes, they are charged. During the charging operation, the potential of the voltage step-up gate control signal V_{TO} is set to be {V_{DD}-Vt(T2)}, and the node P1 is set to be (V_{DD}-Vt(T4)), wherein Vt(T2) and Vt(T4) are threshold voltages (including a component of voltage drop due to a back gate effect) of the MOS transistors T2 and T4, respectively. When the timing signal t_{R} is changed in its state from logically high to low while the timing signal t₁ remains logically high, the power source voltage V_{DD} appears on the negative electrode of the voltage step-up capacitor C1, so that the voltage of the voltage step-up gate control signal V_{TO} is raised to the upper limit of {V_{DD} + Vt(T3)}. The MOS transistor T3 is a part of the limiting circuit 55ac and functions to control the rise in voltage of the signal V_{TO} as a positive potential of the voltage step-up capacitor C1.

When the timing signal t₁ is changed from logically high to low and at the same time the signal t₂ is changed from logically low to high, the voltage applying circuit 55bb makes the negative potential of the voltage step-up capacitor C2 to be logically high. Thus, the node P1 is set to a potential of {V_{DD} + Vt(T5)}, wherein Vt(T5) is a threshold voltage of the transistor T5 including a voltage drop component due to a back gate effect. The MOS transistor T5 is a part of the limiting circuit 55bc and controls the rise in potential of the node P1 in order to avoid the destruction of the transistor T6. The node potential is the positive potential of the capacitor C2. The gate potential of the MOS transistor T6 in the potential transfer circuit 55bd is {V_{DD} + Vt(T5)} and the drain potential thereof is V_{DD}. If the condition of Vt(T6) ≤ Vt(T5) is satisfied, the source potential thereof, that is, the potential of the voltage step-up gate control signal Vgate rises at least to the source potential V_{DD}, so that the capacitor C3 is charged. Vt(T6) is a threshold voltage (including a voltage drop component due to a back gate effect) of the MOS transistor T6.

When the timing signal t₃ is changed from logically low to high while the timing signal t₂ remains logically high, the potential applying circuit 55be controls to raise the negative potential of the capacitor C3 to the source potential V_{DD}, which makes the potential of the voltage step-up gate control signal Vgate to rise to the extent that it exceeds the source potential V_{DD}. Provided that the charged voltage of the capacitor C3 is represented by Vc3, the potential of the signal Vgate is expressed by {V_{DD} + Vc3}. The timing signals t_{R}, t₁ are then changed from logically low to high and the timing signals t₂, t₃ are changed from logically high to low. While the timing signal t₁ is logically high, the MOS transistor T7 which is part of the discharging circuit 55bf is activated to thereby maintain the potential of the signal Vgate to be logically low.

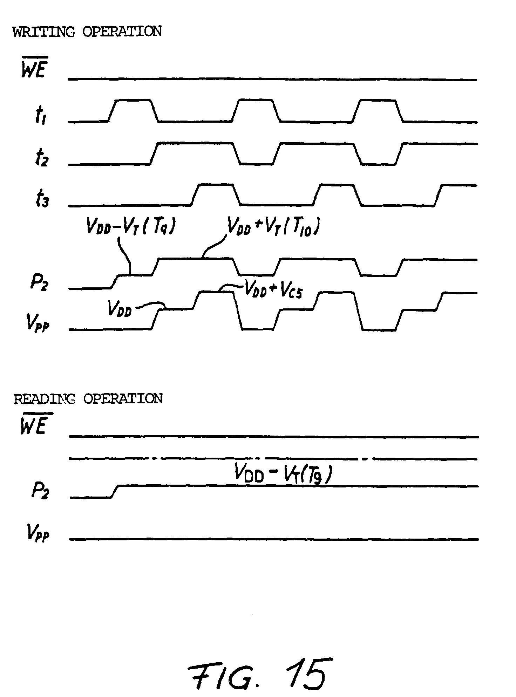

Referring now to Fig. 15, the operation of the stepped-up potential generating circuit 56 will be described. The writing operation is defined by the period during which the write enable signal $\overline{\text{WE}}$ is maintained logically low. Firstly, when the timing signal t₁ is changed from high to low while the timing signals t₂ and t₃ are low, the MOS transistor T8 of the charge injection circuit 56a is activated to switch the MOS transistor T9 on. Hence, the capacitor C4 is charged because the potential of its negative electrode is low. During this charging operation, the potential of the node P2 is set to be {V_{DD}-Vt(T9)} as shown in Fig. 15, wherein Vt(T9) is a threshold voltage (including a voltage drop component due to a back gate effect) of the MOS transistor T9.

When the timing signal t₁ becomes logically low and the timing signal t₂ logically high, the potential applying circuit 56b raises the negative potential of the capacitor C4 to reach the potential V_{DD}. Therefore, the potential of the node P2 rises to reach the upper limit of {V_{DD} + Vt(T10)} wherein Vt(T10) is a threshold voltage (including a voltage drop component due to a back gate effect) of the MOS transistor T10. The MOS transistor T10 is a part of the limiting circuit 56c and functions to control the potential rise of the node P2 so as not to destruct the MOS transistor T11. At the same time, the potential applying circuit 56e applies the source potential V_{DD} to the drain of the MOS transistor T11 of the potential transfer circuit 56d. Since the gate potential of the MOS transistor T11 is {V_{DD} + Vt(T10)} and the drain potential thereof is V_{DD}, if the following formula is satisfied, the source potential thereof, that is, the potential Vpp is raised at least to the source potential V_{DD} and therefore the charging of the capacitor C5 is carried out.$\text{Vt(T11) ≤ Vt(T10)}$ wherein Vt(T11) is a threshold voltage (including a voltage drop component due to a back gate effect) of the MOS transistor T11.

Next, when the timing signal t₃ is changed to be logically high, the potential applying circuit 56f makes to raise the negative potential of the capacitor C5 to the source potential V_{DD}, and the potential Vpp rises to exceed the source potential V_{DD}. The stepped-up potential Vpp is expressed by {V_{DD} + Vc5}, wherein Vc5 represents the charged voltage of the capacitor C5. Thereafter, the timing signal t₁ is changed to be logically high and the timing signals t₂ and t₃ are changed to be logically low. The potential of the signal Vpp is maintained to be logically low during the logically low period of the timing signal t₁.

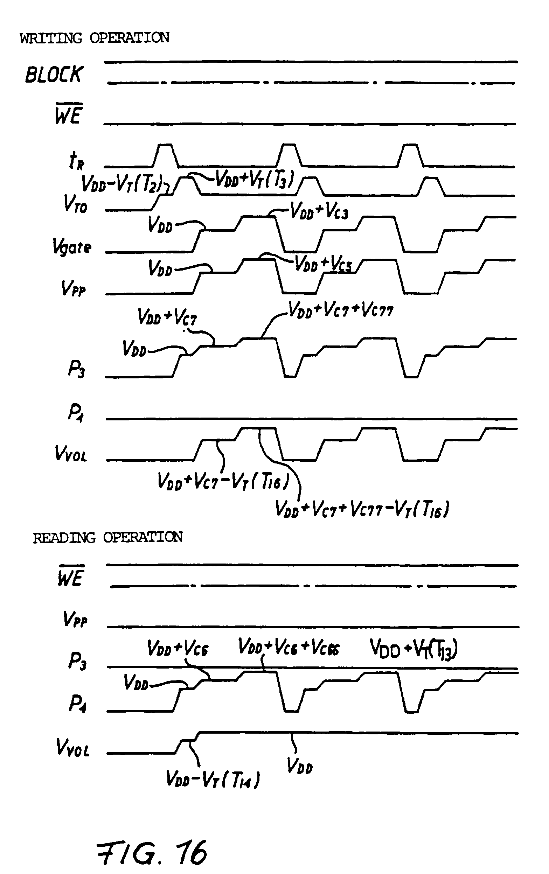

With reference to Fig. 16, the writing operation of the word line potential synthesizing circuit 57 will be explained. In the writing operation, the write enable signal $\overline{\text{WE}}$ is set to be logically low so that the source potential supplying circuit 57a is not activated to supply the source potential V_{DD} as word line supplying potential V_{VOL}. When the timing signal t_{R} is changed from logically high to low, the logic circuit 57ba raises the drain potential of the MOS transistor T15 of the potential transfer circuit 57bb to the source potential V_{DD}. The potential of the voltage step-up gate control signal V_{TO} is elevated to {V_{DD} + Vt(T3)}. Hence, the potential of the node P3 is set to be {V_{DD} + Vt(T3) - Vt(T15)} (=V_{DD}) so that the charging of the capacitor C7 is carried out. Vt(T15) is a threshold voltage (including a voltage drop component due to a back gate effect) of the MOS transistor T15.

When the potential of the signal Vgate and the stepped-up potential Vpp are elevated to the source potential V_{DD}, the potential of the node P3 is set to exceed the source potential V_{DD} and to be {V_{DD} + Vc7}, wherein Vc7 represents the charging voltage of the capacitor C7. At this moment, the gate potential of transistor T16 of the potential transfer circuit 57bc is {V_{DD} + Vc7} and the drain potential thereof is the stepped-up potential Vpp (=V_{DD}), so that the word line supplying potential V_{VOL} becomes {V_{DD} + Vc7 - Vt(T16)}, wherein Vt(T16) is a threshold voltage (including a voltage drop component due to a back gate effect) of the MOS transistor T16. Where Vc7 is set to be equal to or larger than Vt(T16), the word line supplying voltag V_{VOL} becomes V_{DD}. When the potential of the voltage setp-up gate control signal Vgate becomes {V_{DD} + Vc3}, the gate potential of transistor T16 of the potential transfer circuit 57bc becomes {V_{DD} + Vc7 + Vc77} and therefore the word line supplying potential V_{VOL} is further elevated to become {V_{DD} + Vc7 + Vc77 - Vt(T16)}. Vc77 represents a potential increase by the second step-up operation. Accordingly, the word line supplying potential V_{VOL} is stepped up through two-stage step-up operation so as to sufficiently exceed the source potential V_{DD}.

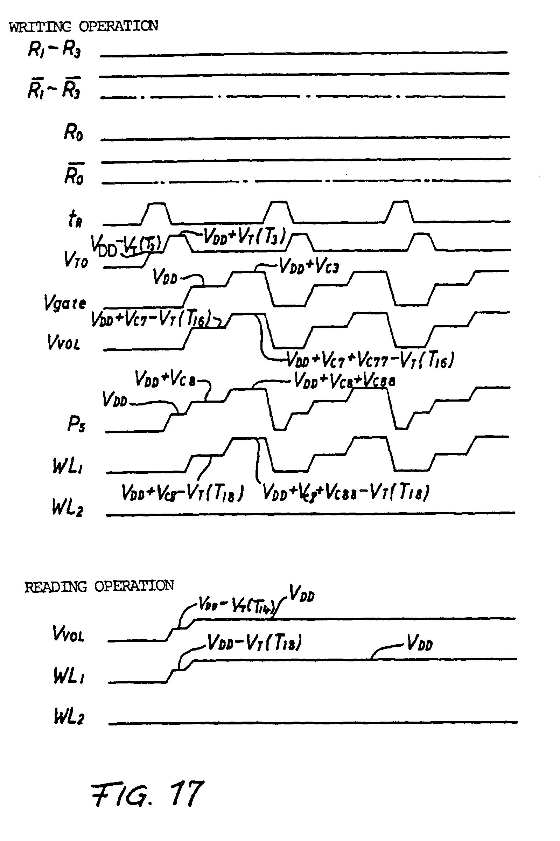

Fig. 17 illustrates the writing operation of the word line potential applying circuit. In the following, explanation will be made as to the case where the word line WL1 is selected. In response to the X-address buffer ouputs R0-R3, $\overline{\text{R0}}$-$\overline{\text{R3}}$, the X-address decoder and word line buffer circuit 22a generates the source potential V_{DD}. The first potential delivering circuit 59a is activated while the word line discharging circuit 59e is not activated. More specifically, when the potential of the voltage step-up control signal V_{TO} becomes {V_{DD} + Vt(T3)}, the potential of the node P5, which is the source potential of the MOS transistor T17, is set to be {V_{DD} + Vt(T3) - Vt(T17)} (= V_{DD}), by which the capacitor C8 is charged. Whereas, when the potential of the voltage step-up gate control signal Vgate becomes the power source voltage V_{DD}, the node potential of the node P5 is elevated to be {V_{DD} + Vc8}, wherein Vc8 represents the charged voltage of the capacitor C8. At this moment, the word line supplying potential V_{VOL} is {V_{DD} + Vc7-Vt(T16)}, and the potential applied to the word line WL1 is {V_{DD} + Vc8 - Vt(T18)}. In addition, when the potential of the gate control signal Vgate becomes the source potential {V_{DD} + Vc3}, the node P5 potential is elevated to be as high as {V_{DD} + Vc8 + Vc88} (Vc88 represents a potential increase by the second step-up operation). Simultaneously, the word line supplying potential V_{VOL} is elevated to be {V_{DD} + Vc7 + Vc77 - Vt(T16)}. Therefore, the maximum potential applied to the word line WL1 becomes {V_{DD} + Vc8 + Vc88 - Vt(T18)}.

The following formula (5) can be obtained by substituting the source potential V_{DD} for the maximum potential Vmax in the above formula (3).$\text{Vmax > Vt1 + Vt2 + Vb}$

Provided that Vt1 and Vt2 were set to be 0.9 V while Vb were set to be 0.6 V in view of the semiconductor manufacturing process, the writing word line potential Vmax should be higher than 2.4 V. If the maximum potential Vmax is set to be 1.8 V_{DD}, the source potential Vdd should be higher than 1.33 V. The decrease in value of the source potential V_{DD} is beneficial for the battery source in terms of simplification thereof. According to the present invention, the data writing can be carried out even by using a power source comprised of a single dry battery. Although the above formula (5) is established by the two-stage potential step-up, it can be satisfied by a single-stage potential step-up using a higher charging voltage. Where a higher charging voltage is impossible or where it is desirable to assure a high stepped-up potential, a multiple-stage voltage step-up circuit may be utilized. The voltage step-up means may be a charge pump.

After the word line WL1 is applied with the stepped-up potential, the timing signal t_{R} is changed to be logically high and, in response, the discharge timing signal t_{RO} is generated. During the period that the timing signal t_{RO} is high, the voltage step-up capacitor discharge circuit 59d is activated to discharge the capacitor C8 and therefore the potential of the node P5 is maintained to be logically low.

The reading operation will now be explained. In reading, the ring oscillator circuit 51 is driven and the transformation timing signal generating circuit 54 generates the timing signals t_{R}, t₁, t₂ and t₃ as shown in Fig. 13. In the step-up potential generating circuit 56, although the first stage of the charge injection circuit 56a is activated, the potential applying circuits 56b, 56e and 56f are not activated because the write enable signal $\overline{\text{WE}}$ is maintained logically high. Thus, the stepped-up potential Vpp remains logically low as shown in Fig. 15.

In the word line potential synthesizing circuit 57, since the write enable signal $\overline{\text{WE}}$ is high and the stepped-up potential Vpp is low, the potential of the node P3 is fixed to be logically low as shown in Fig. 16 and therefore the MOS transistor T16 is in a non-driven condition. Where the write enable signal $\overline{\text{WE}}$ is high, the drain potential of the MOS transistor T12 is set to be the source potential V_{DD}, whereas when the voltage step-up gate control signal V_{TO} becomes {V_{DD} + Vt(T3)}, the potential of the node P4 is set to be the source potential V_{DD} and the charging of the capacitor C6 is carried out. Thereafter, when the potential of the voltage step-up gate control signal Vgate becomes the source potential V_{DD}, the potential of the node P4 is elevated to be (V_{DD} + Vc6), wherein Vc6 represents the charging voltage of the capacitor C6. Then, when the potential of the voltage step-up gate control signal Vgate becomes the source potential (V_{DD} + Vc3), the potential of the node P4 is elevated temporarily to be (V_{DD} + Vc6 + Vc66). The node potential is then lowered to {V_{DD} + Vt(T13)} under the control of the limiting circuit 57ad. Vt(T13) represents a threshold voltage (including a voltage drop component due to a back gate effect) of the MOS transistor T13 and Vc66 represents the increase in potential obtained by the second step-up operation. The MOS transistor T14 is prevented from being destructed by the limiting circuit 57ad. So long as the threshold voltage Vt(T14) is maintained to be equal to or less than Vt(T13), the word line supplying potential V_{VOL}, which is generated during data reading operation, is set to be equal to the source potential V_{DD} as shown in Fig. 16.

With reference to Fig. 17, the read operation of the word line potential applying control circuit will be explained. In the following, the read operation wherein the word line WL1 is selected will be explained by way of example. In response to the X-address buffer outputs RO-R3, $\overline{\text{RO}}$-$\overline{\text{R3}}$, the X-decoder and word line buffer 22a generates the source potential V_{DD}. The word line discharging circuit 59e is not driven while the first potential delivering circuit 59a is driven. More specifically, when the potential of the control signal V_{TO} becomes {V_{DD} + Vt(T3)}, the potential of the node P5 which is the source potential of the MOS transistor T17 is set to be {V_{DD} + Vt(T3) - Vt(T17)} (= V_{DD}), and therefore the charging of the capacitor C8 is carried out. Next, when the potential of the signal Vgate becomes the source potential V_{DD}, the potential of the node P5 is elevated to be (V_{DD} + Vc8) and the word line supplying potential V_{VOL} is set to be V_{DD}. During the reading operation, a selected word line is supplied directly with the source potential V_{DD}.

In the present embodiment, multiple step-up operation is carried out by the ring oscillator circuit 51 during the writing operation, and the writing of the same data is tried into the same memory cell for several times. Therefore, even if the first writing of data into a memory cell is not carried out properly, the same data is securely written into the memory cell by the second or later writings. Hence, the proper writing can be obtained.

There is a time lag between the point when the voltage step-up operation begins and that when the maximum stepped-up potential is obtained. The time lag introduces a period in which the word line potential is temporarily low when the memory cells are activated. In other words, a transition period appears between the state wherein a word line is not selected and that wherein the word line is selected. As shown in Fig. 17, the transition period in the writing operation is such that the potential of the selected word line changed from OV to (V_{DD} + Vc8) - Vt(T18), whereas that in the reading operation is such that the potential is changed from OV to V_{DD} - Vt(T18).

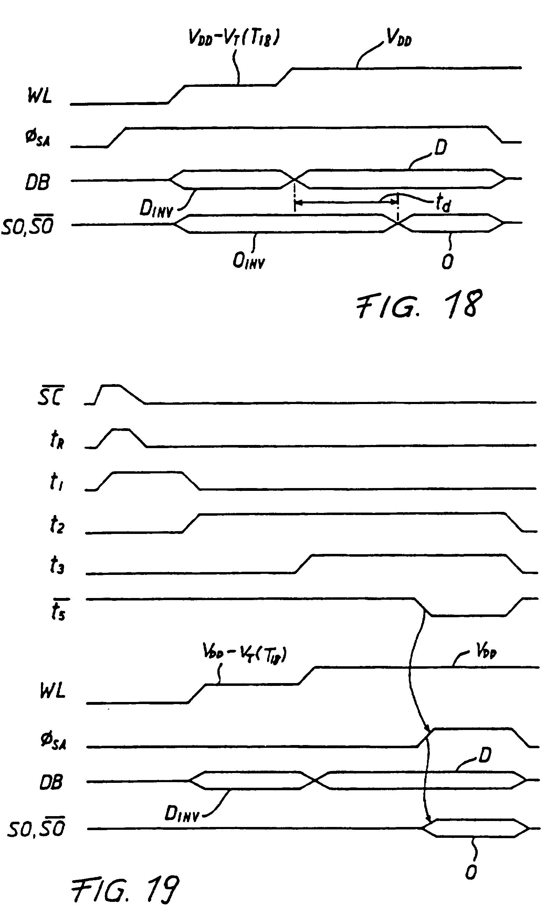

In connection with the transition period in the reading operation, referring to Fig. 18, there will be described a generation of the sense amplifier control signal Φ_{SA} under the control of the internal timing circuit 31, which is carried out before the word line potential is not sufficiently elevated. When noises are induced during the step-up of the word line potential, there is a possibility that the potential on the data line DB is adversely effected by noises, which can make the data D which is to be read on the data line DB to be an inverted data Dinv. If the inverted data Dinv is set on the data line instead of the original data D, the potential of the inverted data is amplified since the sense amplifier circuit 33 has already been activated by application of the sense amplifier control signal Φ_{SA}. The sense amplifier 33 is set for its output to be an inverted signal Oinv obtained by amplifying the potential of the inverted data Dinv. Thereafter, if the original data D appears on the data line, it needs a relatively large amount of time td before the proper output signal O which is obtained by amplifying the potential of the data D appears on the outputs SO and $\overline{\text{SO}}$ of the sense amplifier 33. In order to avoid such a time delay td. according to the present embodiment, the following circuit structure is adapted.

The present embodiment is provided with the voltage step-up detection circuit 39 which detects the completion of the step-up operation based on the timing signal t₃ supplied from the word line potential transformation circuit 50 and generates the detection signal $\overline{\text{t₅}}$, and the sense amplifier control circuit 38 which activates the sense amplifier circuit 33 according to the detection signal $\overline{\text{t₅}}$ after completion of the step-up of the potential of the word lines. As is apparent from Fig. 14, the voltage step-up gate control signal Vgate is set to be a maximum potential when the timing signal t₃ is high. The stepped-up applying potential {V_{DD} + Vc8 + Vc88 - Vt(T18)} appears on the word line when the step-up gate control signal Vgate is set to be the maximum potential. In the reading operation, the word line is set to be the source potential V_{DD} before the timing signal t₃ becomes high. Therefore, according to the present embodiment, the sense amplification control signal Φ_{SA} is generated after the timing signal t₃ changes from low to high in reading operation. As shown in Fig. 19, the step-up detection circuit 39 generates the detection signal $\overline{\text{t₅}}$ which has its level dropped a prescribed period of time after the timing signal t₃ rises and risen at the same time when the timing signal t₃ drops.

The sense amplifier control circuit 38 supplies the sense amplifier control signal Φ_{SA} to the sense amplifier circuit 33, wherein the signal Φ_{SA} has its level risen at the same time when the detection signal $\overline{\text{t₅}}$ drops and dropped at the same time when the signal $\overline{\text{t₅}}$ rises. The sense amplifier circuit 33 when receiving the signal Φ_{SA} is activated and amplifies the potential difference of the data line. As described above, since the sense amplifier 33 is activated after completion of word line potential step-up, the improper inverted data Dinv which is introduced by the noises appearing on the data line will not be amplified. Therefore, the proper data D appearing on the data line is amplified via the sense amplifier 33. The amplified voltage of the inverted data Dinv varies depending on the amount of induced noises and so the time consumption for compensating the such erroneous data varies accordingly. In contrast, according to the present embodiment, such a time consumption can be avoided. In the present embodiment, the control signal from the bit-line/data-line load control circuit 36 is also generated in accordance with the timing signal $\overline{\text{t₅}}$.

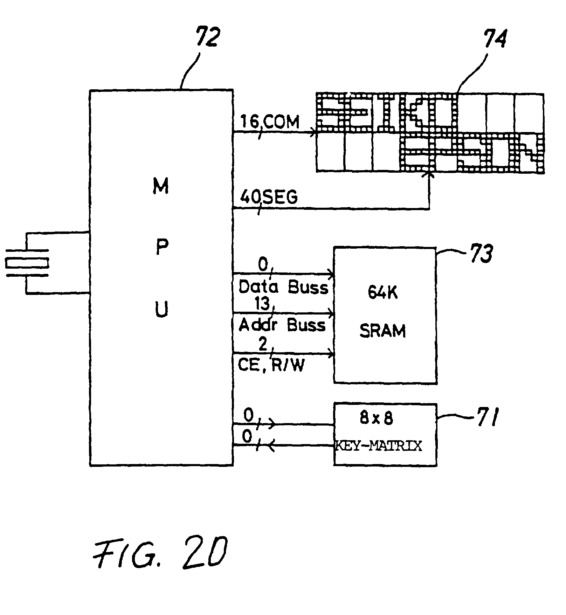

The SRAM of Fig. 1 can be adopted for use in electronic devices such as a table calculator of Fig. 20 and the like. This type of portable electronic device functions to store data such as date, time and the like which is input through a key matrix 71 into an SRAM 73 under the control of a microprocessor unit (MPU) 72 and displays the stored data in the SRAM 73 on an LCD panel 74 in accordance with instructions input through the key matrix. This type of device must be of compact size and light weight and have a prolonged life time rather than a high processing speed. Thus, it is preferable that this type of device is provided with the SRAM of Fig. 1 which is capable of being driven by a relatively low voltage so that such a device can be operated by a reduced number of dry batteries or a reduced-capacity-type dry battery.

## Claims

1. A semiconductor memory device comprising
a memory cell (1) having a flip-flop circuit which has a first load means (HR1) and a first insulated gate field effect transistor (N1) forming a series connection to which a power source voltage is applied, and a second load means (HR2) and a second insulated gate field effect transistor (N2) forming a series connection to which said power source voltage is applied, and insulated gate field effect transistors (N3, N4) for accessing which are connected between memory nodes (n1, n2) of said flip-flop circuit and bit lines (BL, $\overline{\text{BL}}$) and receive a voltage of a word line ($\overline{\text{WL}}$) as a gate input, and
a word line voltage transformation means (50) for stepping up the voltage of said word line, when selected for data writing, to a writing voltage (V_{VOL}) which exceeds said power source voltage (V_{DD}) within at least part of a data writing interval,
characterized in that
the word line voltage transformation means (50) comprises means for repeatedly conducting, during the same data writing interval, a potential stepping up and down operation between ground and said writing voltage.

2. A semiconductor memory device according to claim 1 or 2, wherein the word line voltage transformation means (50) comprises a voltage multi-step-up means (51, 54-57, 59) which produces the writing voltage through at least two stages of step-up operations.

3. A semiconductor memory device according to claim 1, wherein the word line voltage transformation means (50) comprises:
oscillator means (51) generating recurring pulses during the writing operation;
voltage transformation timing signal generating means (54) generating timing signals based on the above pulses;
step-up voltage generating means (56) for generating a step-up voltage according to a selected signal among the timing signals, the value of said voltage exceeding the power source voltage (V_{DD});
step-up voltage control signal generating means (55) for generating a voltage step-up control signal according to a selected signal among the timing signals, the voltage of said signal exceeding the power source voltage;
word line supply voltage synthesizing means (57) receiving the step-up potential from the step-up voltage generating means and the source potential from the power source voltage, and selectively outputting one of the received potentials as a word line supply potential in accordance with the step-up voltage control signal; and
word line potential applying control means (59) controlling the application of the word line supply voltage to a word line to be selected, in accordance with the selected timing signal and voltage step-up control signal.

4. A semiconductor memory device according to claim 3, wherein the oscillator means (51) is a ring oscillator means.

5. A semiconductor memory device according to claim 4, wherein the ring oscillator means (51) has a ring oscillator comprising a plurality of logic circuits, and a selective driving means (53) which activates the ring oscillator selectively in accordance with internal signals.

6. A semiconductor memory device according to any one of claims 3 to 5, wherein the voltage transformation timing signal generating means (54) has a plurality of logic circuits (101-105, 109-111, 114, 116-127) and a plurality of delay circuits (112, 113, 115).

7. A semiconductor memory device according to any one of claims 3 to 6, wherein the step-up voltage generating means (56) has a charging means (56a, 56b, 56c, 56d, 56e, C4) which charges a first voltage step-up capacitor (C5) according to a selected signal among the timing signals, and a first potential applying means (56f) for changing a potential of said capacitor in accordance with a pre-selected signal among the timing signals.

8. A semiconductor memory device according to claim 7, wherein the charging means has:
a charge injection means (56a) which charges a second voltage step-up capacitor (C4) according to a selected signal among the timing signals;
a second potential applying means (56b) for changing a potential of the second voltage step-up capacitor in accordance with a selected signal among the timing signals;
a potential transfer means (56d) for receiving the stepped-up potential of the second voltage step-up capacitor as a control input in accordance with a selected signal among the timing signals; and
a third potential applying means (56e) which applies said power source voltage (V_{DD}) to the potential transfer means in accordance with a selected signal among the timing signals.

9. A semiconductor memory device according to any one of claims 3 to 8, wherein the step-up voltage generating means (56) has a limiting means (56c) which limits an increase in voltage by the voltage stepping-up operation.

10. A semiconductor memory device according to any one of claim 3 to 9, wherein the step-up voltage control signal generating means (55) has a first step-up voltage control signal generating means (55a) which generates a first step-up voltage control signal (V_{TO}), and a second step-up voltage control signal generating means (55b) which generates a second step-up voltage control signal (V_{gate}).

11. A semiconductor memory device according to claim 10, wherein the first step-up voltage control signal generating means (55a) has a charge injection means (55aa) which charges a voltage step-up capacitor (C₁) according to a selected signal among the timing signals, and a potential applying means ((55ab) for changing a potential of said capacitor in accordance with selected signals among the timing signals.

12. A semiconductor memory device according to claim 10 or 11, wherein the first step-up voltage control signal generating means (55a) has a limiting means (55ac) which limits an increase in voltage by the voltage stepping-up operation.

13. A semiconductor memory device according to any one of claims 10 to 12, wherein the second step-up voltage control signal generating means (55b) has a charging means (55ba, 55bb, 55bc, 55bd, C₂) which charges a first voltage step-up capacitor (C₃) according to pre-selected signals among the timing signals, and a first potential applying means (55be) for changing a potential of said capacitor in accordance with selected signals among the timing signals.

14. A semiconductor memory device according to claim 13, wherein the charging means has:
a charge injection means (55ba) which charges a second voltage step-up capacitor (C₂) according to a selected signal among the timing signals;
a second potential applying (55bb) means for increasing the potential at an electrode of the second voltage step-up capacitor in accordance with selected signals among the timing signals; and
a potential transfer means (55bd) for receiving a stepped-up potential from the second step-up voltage capacitor and sending out the received potential in accordance with pre-selected signals among the timing signals.

15. A semiconductor memory device according to any of claims 3 to 14, wherein the word line supply voltage synthesizing means (57) has a power source voltage supplying portion (57a) which supplies one potential of said power source voltage (V_{DD}) to the word line potential applying control means (59) when the data reading operation is selected, and a step-up voltage supplying means (57b) which supplies the writing voltage to the word line potential applying control means when the writing operation is selected.

16. A semiconductor memory device according to claim 15, wherein the power source voltage supplying portion (57a) has a first potential transfer means (57ab) which is controlled by the first step-up voltage control signal (V_{TO}) based on intemal signals, and a voltage step-up capacitor (C₆) which begins voltage stepping-up operation when it receives the second step-up voltage control signal (V_{gate}), and a second potential transfer means (57ac) for transferring one potential of said power source voltage in accordance with the charged potential of said capacitor.

17. A semiconductor memory device according to any one of claims 15 or 16, wherein the step-up voltage supplying means (57b) has a first potential transfer means (57bb) which is controlled by the first step-up voltage control signal (VT_{O)}on the basis of internal signals and a selected signal among the timing signals, and a voltage step-up capacitor (C₇) which begins voltage step-up operation when it receives the second step-up voltage control signal (V_{gate}), and a second potential transfer means (57bc) for transferring the step-up voltage in accordance with the charged potential of the above capacitor.

18. A semiconductor memory device according to any one of claims 15 to 17, wherein the power source voltage supplying portion (57a) has a limiting means (57ad) which limits an increase in voltage by the voltage stepping-up operation.

19. A semiconductor memory device according to any one of claims 10 to 18, wherein the word line potential applying control means has a first potential transfer means which transfers a selected potential of a line decoder and word line buffer means (22) under the control of the second voltage step-up control signal (V_{gate}) to a step-up capacitor (C₈, C₉) which begins voltage stepping-up operation, and a second potential transfer means (59b) which supplies the word line supplying voltage to the word line under control of the step-up voltage.

20. A semiconductor memory device according to claim 19, wherein the word line potential applying control means (59) has a discharge timing means (59c) which generates a discharge timing signal (t_{RO}) when it receives internal signals and selected signals among the timing signals, and a discharging means (59d) which discharges the voltage step-up capacitor (C₈, C₉) according to said discharge timing signal.

21. A semiconductor memory device according to claim 19 or 20, wherein the word line potential applying control means (59) has a word line discharging means (59e) which discharges the charge of the word line in accordance with a potential representing a non-selected condition by the line decoder and word line buffer means (22).

22. A semiconductor memory device according to any one of claims 7 to 21, wherein one electrode of each of said step-up capacitors is formed by a first semiconductor layer and the other electrodes of each of said capacitors are formed by a second semiconductor layer provided via an insulating layer on said first semiconductor layer.

23. A semiconductor memory device according to claim 22, wherein the negative electrode of each of said step-up capacitors is formed by the second semiconductor layer, and the positive electrode of each of said capacitors is formed by the first semiconductor layer.

24. A semiconductor memory device according to any one of claims 1 to 23, wherein the first and second load means (HR2, HR1) are high resistance type load elements.

25. A semiconductor memory device according to claim 24, wherein the high resistance type load elements are of polysilicon of high resistance.

26. A semiconductor memory device according to claim 24, wherein the high resistance type load elements are of load type MOS elements.

27. A semiconductor memory device according to any one of the preceding claims, wherein the word line voltage transformation means (50) has a potential applying control means (59) for applying said writing voltage to the word line when the writing operation is selected and for applying a voltage lower than said writing voltage to the word line when the data reading operation is selected.

28. A semiconductor memory device according to claim 27, further comprising an applied potential detecting means (39) which detects a point when the potential of the word line is set to be one for data reading operation, and a sense amplifier control means (38) which generates a sense amplifier control signal for activating a sense amplifier means based on the output of the applied potential detecting means.

29. A data processing device having a memory device according to any of the preceding claims for storing data, a logical operation means which performs logic operation of data, and an input/output means which performs input or output of the data.

## Patentansprüche

1. Halbleiter-Speichervorrichtung, umfassend
eine Speicherzelle (1) mit einer Flipflop-Schaltung, die eine erste Lasteinrichtung (HR1) und einen ersten Feldeffekttransistor (N1) mit isoliertem Gate, die eine Reihenschaltung bilden, an die eine Stromquellenspannung angelegt wird, und eine zweite Lasteinrichtung (HR2) und einen zweiten Feldeffekttransistor (N2) mit isoliertem Gate, die eine Reihenschaltung bilden, an die die Stromquellenspannung angelegt wird, aufweist, und mit Feldeffekttransistoren (N3, N4) mit isoliertem Gate für den Zugriff, die zwischen Speicherknoten (n1, n2) der Flipflop-Schaltung und Bitleitungen (BL, $\overline{\text{BL}}$) geschaltet sind, und eine Spannung einer Wortleitung ($\overline{\text{WL}}$) als ein Gateeingangssignal empfangen, und
eine Wortleitungsspannungs-Transformationseinrichtung (50) zum Erhöhen der Spannung der Wortleitung, wenn sie zum Datenschreiben ausgewählt ist, auf eine Schreibspannung (V_{VOL}), die die Stromquellenspannung (V_{DD}) übersteigt, innerhalb wenigstens eines Teiles des Datenschreibintervalls,
dadurch gekennzeichnet, daß
die Wortleitungsspannungs-Transformationseinrichtung (50) eine Einrichtung enthält zum wiederholten Durchführen, während desselben Datenschreibintervalls, eines Potentialerhöhungs- und -erniedrigungsbetriebs zwischen Masse und der Schreibspannung.

2. Halbleiter-Speichervorrichtung nach Anspruch 1 oder 2, bei der die Wortleitungsspannungs-Transformationseinrichtung (50) eine Spannungs-Mehrstufen-Erhöhungseinrichtung (51, 54-57, 59) umfaßt, welche die Schreibspannung über wenigstens zwei Stufen von Erhöhungsbetriebsläufen erzeugt.

3. Halbleiter-Speichervorrichtung nach Anspruch 1, bei der die Wortleitungsspannungs-Transformationseinrichtung (50) umfaßt:
eine Oszillatoreinrichtung (51), die während der Schreiboperation wiederkehrende Impulse erzeugt,
eine Spannungstransformations-Zeitsteuersignal-Generatoreinrichtung (54), die auf der Basis der obigen Impulse Zeitsteuersignale erzeugt,
eine Erhöhungsspannungs-Generatoreinrichtung (56) zur Erzeugung einer Erhöhungsspannung nach Maßgabe eines ausgewählten Signals unter den Zeitsteuersignalen, wobei der Wert der Spannung die Stromquellenspannung (V_{DD}) übersteigt,
eine Erhöhungsspannungs-Steuersignal-Generatoreinrichtung (55) zur Erzeugung eines Erhöhungsspannungs-Steuersignals nach Maßgabe eines ausgewählten Signals unter den Zeitsteuersignalen, wobei die Spannung des Signals die Stromquellenspannung übersteigt,
eine Wortleitungs-Lieferspannungs-Synthetisiereinrichtung (57), die das Erhöhungspotential von der Erhöhungsspannungs-Generatoreinrichtung und das Quellenpotential von der Stromquellenspannung erhält und selektiv eines der empfangenen Potentiale als ein Wortleitungs-Lieferpotential nach Maßgabe des Erhöhungsspannungs-Steuersignals ausgibt, und
eine Wortleitungspotential-Anlegesteuereinrichtung (59), die das Anlegen der Wortleitungs-Lieferspannung an eine auszuwählende Wortleitung nach Maßgabe des ausgewählten Zeitsteuersignals und des Erhöhungsspannungs-Steuersignals steuert.

4. Halbleiter-Speichervorrichtung nach Anspruch 3, bei der die Oszillatoreinrichtung (51) eine Ringoszillatoreinrichtung ist.

5. Halbleiter-Speichervorrichtung nach Anspruch 4, bei der die Ringoszillatoreinrichtung (51) einen Ringoszillator aufweist, der eine Vielzahl von logischen Schaltungen und eine selektive Treibereinrichtung (53) umfaßt, welche den Ringoszillator selektiv nach Maßgabe interner Signale aktiviert.

6. Halbleiter-Speichervorrichtung nach einem der Ansprüche 3 bis 5, bei der die Spannungstransformations-Zeitsteuersignal-Generatoreinrichtung (54) eine Vielzahl logischer Schaltungen (101-105, 109-111, 114, 116-127) und eine Vielzahl von Verzögerungsschaltungen (112, 113, 115) aufweist.

7. Halbleiter-Speichervorrichtung nach einem der Ansprüche 3 bis 6, bei der die Erhöhungsspannungs-Generatoreinrichtung (56) eine Ladeeinrichtung (56a, 56b, 56c, 56d, 56e, C4), die einen ersten Spannungserhöhungs-Kondensator (C5) nach Maßgabe eines ausgewählten Signals unter den Zeitsteuersignalen lädt, und eine erste Potential-Anlegeeinrichtung (56f) zur Änderung eines Potentials des Kondensators nach Maßgabe eines vorausgewählten Signals unter den Zeitsteuersignalen aufweist.

8. Halbleiter-Speichervorrichtung nach Anspruch 7, bei der die Ladeeinrichtung aufweist:
eine Ladungs-lnjektionseinrichtung (56a), die einen zweiten Spannungserhöhungs-Kondensator (C4) nach Maßgabe eines ausgewählten Signals unter den Zeitsteuersignalen auflädt,
eine zweite Potential-Anlegeeinrichtung (56b) zur Änderung eines Potentials des zweiten Spannungserhöhungs-Kondensators nach Maßgabe eines ausgewählten Signals unter den Zeitsteuersignalen,
eine Potential-Übertragungseinrichtung (56d) zum Empfang des erhöhten Potentials des zweiten Spannungserhöhungs-Kondensators als eines Steuereingangssignals nach Maßgabe eines ausgewählten Signals unter den Zeitsteuersignalen, und
eine dritte Potential-Anlegeeinrichtung (56e), die die Stromquellenspannung (V_{DD}) an die Potential-Übertragungseinrichtung nach Maßgabe eines ausgewählten Signals unter den Zeitsteuersignalen anlegt.

9. Halbleiter-Speichervorrichtung nach einem der Ansprüche 3 bis 8, bei der die Erhöhungsspannungs-Generatoreinrichtung (56) eine Begrenzereinrichtung (56c) aufweist, die einen Spannungsanstieg durch den Spannungserhöhungsbetrieb begrenzt.

10. Halbleiter-Speichervorrichtung nach einem der Ansprüche 3 bis 9, bei der die Erhöhungsspannungs-Steuersignal-Generatoreinrichtung (55) eine erste Erhöhungsspannungs-Steuersignal-Generatoreinrichtung (55a), die ein erstes Erhöhungsspannungs-Steuersignal (V_{TO}) erzeugt, und eine zweite Erhöhungsspannungs-Steuersignal-Generatoreinrichtung (55b), die ein zweites Erhöhungsspannungs-Steuersignal (V_{gate}) erzeugt, aufweist.

11. Halbleiter-Speichervorrichtung nach Anspruch 10, bei der die erste Erhöhungsspannungs-Steuersignal-Generatoreinrichtung (55a) eine Ladungs-lnjektionseinrichtung (55aa), die einen Spannungserhöhungs-Kondensator (C₁) nach Maßgabe eines ausgewählten Signals unter den Zeitsteuersignalen auflädt, und eine Potential-Anlegeeinrichtung (55ab) zur Änderung eines Potentials des Kondensators nach Maßgabe ausgewählter Signale unter den Zeitsteuersignalen aufweist.

12. Halbleiter-Speichervorrichtung nach Anspruch 10 oder 11, bei der die erste Erhöhungsspannungs-Steuersignal-Generatoreinrichtung (55a) eine Begrenzereinrichtung (55ac) aufweist, die einen Spannungsanstieg durch den Spannungserhöhungsbetrieb begrenzt.

13. Halbleiter-Speichervorrichtung nach einem der Ansprüche 10 bis 12, bei der die zweite Erhöhungsspannungs-Steuersignal-Generatoreinrichtung (55b) eine Ladeeinrichtung (55ba, 55bb, 55bc, 55bd, C₂), die einen ersten Spannungserhöhungs-Kondensator (C₃) nach Maßgabe vorausgewählter Signale unter den Zeitsteuersignalen auflädt, und eine erste Potential-Anlegeeinrichtung (55be) zur Änderung eines Potentials des Kondensators nach Maßgabe ausgewählter Signale unter den Zeitsteuersignalen aufweist.

14. Halbleiter-Speichervorrichtung nach Anspruch 13, bei der die Ladeeinrichtung aufweist:
eine Ladungs-lnjektionseinrichtung (55ba), die einen zweiten Spannungserhöhungs-Kondensator (C₂) nach Maßgabe eines ausgewählten Signals unter den Zeitsteuersignalen auflädt,
eine zweite Potential-Anlegeeinrichtung (55bb) zur Erhöhung des Potentials an einer Elektrode des zweiten Spannungserhöhungs-Kondensators nach Maßgabe ausgewählter Signale unter den Zeitsteuersignalen, und
eine Potential-Übertragungseinrichtung (55bd) zum Empfang eines erhöhten Potentials von dem zweiten Erhöhungsspannungs-Kondensator und zum Aussenden des empfangenen Potentials nach Maßgabe vorausgewählter Signale unter den Zeitsteuersignalen.

15. Halbleiter-Speichervorrichtung nach einem der Ansprüche 3 bis 14, bei der die Wortleitungs-Lieferspannungs-Synthetisiereinrichtung (57) einen Stromquellenspannungs-Lieferabschnitt (57a), der ein Potential der Stromquellenspannung (V_{DD}) an die Wortleitungspotential-Anlegesteuereinrichtung (59) liefert, wenn der Datenlesebetrieb ausgewählt ist, und eine Erhöhungsspannungs-Liefereinrichtung (57b), die die Schreibspannung an die Wortleitungspotential-Anlegesteuereinrichtung liefert, wenn der Schreibbetrieb ausgewählt ist, aufweist.

16. Halbleiter-Speichervorrichtung nach Anspruch 15, bei der der Stromquellenspannungs-Lieferabschnitt (57a) eine erste Potential-Übertragungseinrichtung (57ab), die von dem ersten Erhöhungsspannungs-Steuersignal (V_{TO}) auf der Basis interner Signale gesteuert wird, und einen Spannungserhöhungs-Kondensator (C₆), der den Spannungserhöhungsbetrieb beginnt, wenn er das zweite Erhöhungsspannungs-Steuersignal (V_{gate}) empfängt, sowie eine zweite Potential-Übertragungseinrichtung (57ac) zur Übertragung eines Potentials der Stromquellenspannung nach Maßgabe des Ladungspotentials des Kondensators aufweist.

17. Halbleiter-Speichervorrichtung nach einem der Ansprüche 15 oder 16, bei der die Erhöhungsspannungs-Liefereinrichtung (57b) eine erste Potential-Übertragungseinrichtung (57bb), die von dem ersten Erhöhungsspannungs-Steuersignal (V_{TO}) auf der Basis interner Signale und eines ausgewählten Signals unter den Zeitsteuersignalen gesteuert wird, und einen Spannungserhöhungs-Kondensator (C₇), der den Spannungserhöhungsbetrieb beginnt, wenn er das zweite Erhöhungsspannungs-Steuersignal (V_{gate}) empfängt, sowie eine zweite Potential-Übertragungseinrichtung (57bc) zur Übertragung der Erhöhungsspannung nach Maßgabe des Ladungspotentials des obigen Kondensators aufweist.

18. Halbleiter-Speichervorrichtung nach einem der Ansprüche 15 bis 17, bei der der Stromquellenspannungs-Lieferabschnitt (57a) eine Begrenzereinrichtung (57ad) aufweist, die einen Spannungsanstieg durch den Spannungserhöhungsbetrieb begrenzt.

19. Halbleiter-Speichervorrichtung nach einem der Ansprüche 10 bis 18, bei der die Wortleitungspotential-Anlegesteuereinrichtung eine erste Potential-Übertragungseinrichtung, die ein ausgewähltes Potential einer Leitungsdecoder-und-Wortleitungs-Puffereinrichtung (22) unter der Steuerung des zweiten Erhöhungsspannungs-Steuersignals (V_{gate}) an einen Erhöhungs-Kondensator (C₈, C₉) überträgt, der einen Spannungserhöhungsbetrieb beginnt, und eine zweite Potential-Übertragungseinrichtung (59b), die die Wortleitungs-Lieferspannung unter der Steuerung durch die Erhöhungsspannung an die Wortleitung liefert, aufweist.

20. Halbleiter-Speichervorrichtung nach Anspruch 19, bei der die Wortleitungspotential-Anlegesteuereinrichtung (59) eine Entlade-Zeitsteuereinrichtung (59c), die ein Entlade-Zeitsteuersignal (t_{RO}) erzeugt, wenn sie interne Signale und ausgewählte Signale unter den Zeitsteuersignalen empfängt, und eine Entladeeinrichtung (59d), die den Spannungserhöhungs-Kondensator (C₈, C₉) nach Maßgabe des Entlade-Zeitsteuersignals entlädt, aufweist.

21. Halbleiter-Speichervorrichtung nach Anspruch 19 oder 20, bei der die Wortleitungspotential-Anlegesteuereinrichtung (59) eine Wortleitungs-Entladeeinrichtung (59e) aufweist, die die Ladung der Wortleitung nach Maßgabe eines Potentials entlädt, welches einen nicht ausgewählten Zustand durch die Leitungsdecoder-und-Wortleitungs-Puffereinrichtung (22) repräsentiert.

22. Halbleiter-Speichervorrichtung nach einem der Ansprüche 7 bis 21, bei der eine Elektrode jedes der Erhöhungs-Kondensatoren von einer ersten Halbleiterschicht gebildet wird und die anderen Elektroden jedes der Kondensatoren von einer zweiten Halbleiterschicht gebildet werden, die vermittels einer Isolierschicht auf der ersten Halbleiterschicht vorgesehen ist.

23. Halbleiter-Speichervorrichtung nach Anspruch 22, bei der die negative Elektrode jedes der Erhöhungs-Kondensatoren von der zweiten Halbleiterschicht gebildet wird und die positive Elektrode jedes der Kondensatoren von der ersten Halbleiterschicht gebildet wird.

24. Halbleiter-Speichervorrichtung nach einem der Ansprüche 1 bis 23, bei der die erste und die zweite Lasteinrichtung (HR2, HR1) Lastelemente des Typs mit hohem Widerstand sind.

25. Halbleiter-Speichervorrichtung nach Anspruch 24, bei der die Lastelemente des Typs mit hohem Widerstand aus Polysilicium hohen Widerstands bestehen.

26. Halbleiter-Speichervorrichtung nach Anspruch 24, bei der die Lastelemente des Typs mit hohem Widerstand MOS-Elemente des Lasttyps sind.

27. Halbleiter-Speichervorrichtung nach einem der vorhergehenden Ansprüche, bei der die Wortleitungsspannungs-Transformationseinrichtung (50) eine Potential-Anlegesteuereinrichtung (59) aufweist zum Anlegen der Schreibspannung an die Wortleitung, wenn der Schreibbetrieb ausgewählt ist, und zum Anlegen einer Spannung niedriger als die Schreibspannung an die Wortleitung, wenn der Datenlesebetrieb ausgewählt ist.

28. Halbleiter-Speichervorrichtung nach Anspruch 27, ferner umfassend eine Detektoreinrichtung (39) für das angelegte Potential, die einen Punkt erfaßt, zu dem das Potential der Wortleitung auf eines für den Datenlesebetrieb gesetzt ist, und eine Leseverstärker-Steuerschaltung (38), die ein Leseverstärker-Steuersignal zum Aktivieren einer Leseverstärkereinrichtung auf der Basis des Ausgangssignals der Detektoreinrichtung für das angelegt Potential erzeugt.

29. Datenverarbeitungsvorrichtung, die eine Speichervorrichtung nach einem der vorhergehenden Ansprüche zur Speicherung von Daten, eine logische Operationseinrichtung, die logische Operation von Daten ausführt, und eine Eingabe/Ausgabeeinrichtung, die eine Eingabe oder Ausgabe der Daten ausführt, aufweist.

## Revendications

1. Dispositif de mémoire à semi-conducteur comprenant:
une cellule (1) mémoire ayant une bascule qui comporte des premiers moyens (HR1) formant charge et un premier (N1) transistor à effet de champ à grille isolée formant une connexion en série à laquelle une tension de source d'alimentation est appliquée, et des second moyens (HR2) formant charge et un second transistor (N2) à effet de champ à grille isolée formant une connexion en série, à laquelle la tension de source d'alimentation est appliquée, et des transistors (N3, N4) à effet de champ à grille isolée pour les accès, qui sont connectés entre des noeuds (n1, n2) de mémoire de la bascule et des lignes (BL, $\overline{\text{BL}}$) de bits, et reçoivent une tension d'une ligne ($\overline{\text{WL}}$) de mots en tant qu'entrée de grille, et
de moyens (50) de transformation de tension de ligne de mots pour élever la tension de la ligne de mots, lorsqu'elle est sélectionnée pour l'écriture de données, et la porter à une tension (V_{VOL}) d'écriture qui dépasse la tension (V_{DD}) de source d'alimentation au cours d'au moins une partie d'un intervalle d'écriture de données,
caractérisé en ce que
les moyens (50) de transformation de tension de ligne de mots comprennent des moyens pour effectuer de façon répétée, pendant le même intervalle d'écriture de données, une opération d'élévation et d'abaissement du potentiel entre la masse et la tension d'écriture.

2. Dispositif de mémoire à semi-conducteur selon la revendication 1 ou 2, dans lequel les moyens (50) de transformation de tension de ligne de mots comprennent des moyens (51, 54-57, 59) d'élévation de tension à pas multiples qui produisent la tension d'écriture par l'intermédiaire d'au moins deux stades d'opérations d'élévation.

3. Dispositif de mémoire à semi-conducteur selon la revendication 1, dans lequel les moyens (50) de transformation de tension de ligne de mots comprennent:
des moyens (51) oscillateurs générant des impulsions récurrentes pendant l'opération d'écriture;
des moyens (54) générateurs de signal de cadencement de transformation de tension générant des signaux de cadencement à partir des impulsions précitées;
des moyens (56) générateurs de tension d'élévation pour générer une tension d'élévation en fonction d'un signal choisi parmi les signaux de cadencement, la valeur de cette tension dépassant la tension (V_{DD}) de la source d'alimentation;
des moyens (55) générateurs de signal de commande de tension d'élévation pour générer un signal de commande d'élévation de tension en fonction d'un signal choisi parmi les signaux de cadencement, la tension de ce signal dépassant la tension de la source d'alimentation;
des moyens (57) de synthèse de tension d'alimentation de ligne de mots recevant le potentiel d'élévation des moyens générateurs de tension d'élévation et le potentiel de source de la tension de source d'alimentation, et fournissant sélectivement en sortie l'un des potentiels reçus en tant que potentiel d'alimentation de la ligne de mots en fonction du signal de commande de tension d'élévation; et
des moyens (59) de commande d'application de potentiel de ligne de mots commandant l'application de la tension d'alimentation de ligne de mots à une ligne de mots devant être sélectionnée, en fonction des signaux sélectionnés de cadencement et des signaux de commande d'élévation de tension.

4. Dispositif de mémoire à semi-conducteur selon la revendication 3, dans lequel les moyens (51) oscillateurs sont des moyens oscillateurs en anneau.

5. Dispositif de mémoire à semi-conducteur selon la revendication 4, dans lequel les moyens (51) oscillateurs en anneau ont un oscillateur en anneau comprenant une pluralité de circuits logiques, et des moyens (53) d'attaque sélective qui active sélectivement l'oscillateur en anneau en fonction de signaux internes.

6. Dispositif de mémoire à semi-conducteur selon l'une quelconque des revendications 3 à 5, dans lequel les moyens (54) générateurs de signal de cadencement de transformation de tension ont une pluralité de circuits logiques (101-105, 109-111, 114, 116-127) et une pluralité de circuits à retard (112, 113, 115).

7. Dispositif de mémoire à semi-conducteur selon l'une quelconque des revendications 3 à 6, dans lequel les moyens (56) générateurs de tension d'élévation comportent des moyens (56a, 56b, 56c, 56d, 56e, C4) de charge qui chargent un premier condensateur (C5) d'élévation de tension en fonction d'un signal sélectionné parmi les signaux de cadencement, et des premiers moyens (56f) d'application de potentiel pour modifier un potentiel du condensateur en fonction d'un signal pré-sélectionné parmi les signaux de cadencement.

8. Dispositif de mémoire à semi-conducteur selon la revendication 7, dans lequel les moyens de charge comportent :
des moyens (56a) d'injection de charge qui chargent un second condensateur (C4) d'élévation de tension en fonction d'un signal sélectionné parmi les signaux de cadencement,
des second moyens (56b) d'application de potentiel pour modifier un potentiel du second condensateur d'élévation de tension en fonction d'un signal sélectionné parmi les signaux de cadencement; et
des troisième moyens (56e) d'application de potentiel qui appliquent la tension (V_{DD}) de source d'alimentation aux moyens de transfert de potentiel en fonction d'un signal sélectionné parmi les signaux de cadencement.

9. Dispositif de mémoire à semi-conducteur selon l'une quelconque des revendications 3 à 8, dans lequel les moyens (56) générateurs de tension d'élévation ont des moyens (56c) limiteurs qui limitent une augmentation de la tension produite par l'opération d'élévation de tension.

10. Dispositif de mémoire à semi-conducteur selon l'une quelconque des revendications 3 à 9, dans lequel les moyens (55) générateurs de signal de commande de tension d'élévation ont des premier moyens (55a) générateurs de signal de commande de tension d'élévation qui génèrent un premier signal (V_{TO}) de commande de tension d'élévation, et des second moyens (55b) générateurs de signal de commande de tension d'élévation qui génèrent un second signal (V_{déclenchement}) de commande de tension d'élévation.

11. Dispositif de mémoire à semi-conducteur selon la revendication 10, dans lequel les premiers moyens (55a) générateur de signal de commande de tension d'élévation ont des moyens (55aa) d'injection de charge qui chargent un condensateur (C₁) d'élévation de tension en fonction d'un signal sélectionné parmi les signaux de cadencement, et des moyens (55ab) d'application de potentiel pour modifier un potentiel de ce condensateur en fonction de signaux sélectionnés parmi les signaux de cadencement.

12. Dispositif de mémoire à semi-conducteur selon la revendication 10 ou 11, dans lequel les premiers moyens (55a) générateur de signal de commande de tension d'élévation ont des moyens (55ac) de limitation qui limitent un accroissement de tension produit lors de l'opération d'élévation de tension.

13. Dispositif de mémoire à semi-conducteur selon l'une quelconque des revendications 10 à 12, dans lequel les second moyens (55b) générateur de signal de commande de tension d'élévation ont des moyens (55ba, 55bb, 55bc, 55bd, C₂) de charge qui chargent un premier condensateur (C₃) d'élévation de tension en fonction de signaux pré-sélectionnés parmi les signaux de cadencement, et des premiers moyens (55be) d'application de tension pour modifier un potentiel de ce condensateur en fonction de signaux sélectionnés parmi les signaux de cadencement.

14. Dispositif de mémoire à semi-conducteur selon la revendication 13, dans lequel les moyens de charge ont :
des moyens (55ba) d'injection de charge qui chargent un second condensateur (C2) d'élévation de tension en fonction d'un signal sélectionné parmi les signaux de cadencement,
des second moyens (55bb) d'application de potentiel pour augmenter le potentiel à une électrode du second condensateur d'élévation de tension en fonction de signaux sélectionnés parmi les signaux de cadencement; et
des moyens (55bd) de transfert de potentiel pour recevoir un potentiel augmenté du second condensateur d'élévation de tension et envoyer le potentiel reçu en fonction de signaux pré-sélectionnés parmi les signaux de cadencement.

15. Dispositif de mémoire à semi-conducteur selon l'une quelconque des revendications 3 à 14, dans lequel les moyens (57) de synthèse de tension d'alimentation de ligne de mots ont une partie (57a) de fourniture de tension de source d'alimentation qui fournit un potentiel de la tension (V_{DD}) de source d'alimentation aux moyens (59) de commande d'application de potentiel de ligne de mots lorsque l'opération de lecture de données est sélectionnée, et des moyens (57b) de fourniture de tension d'élévation qui fournissent la tension d'écriture au moyen de commande d'application de potentiel de ligne de mots lorsque l'opération d'écriture est sélectionnée.

16. Dispositif de mémoire à semi-conducteur selon la revendication 15, dans lequel la partie (57a) de fourniture de tension de source d'alimentation a des premiers moyens (57ab) de transfert de potentiel qui sont commandés par le premier signal (V_{TO}) de commande de tension d'élévation en fonction de signaux internes, et un condensateur (C₆) d'élévation de tension qui commence une opération d'élévation de tension lorsqu'il reçoit le second signal (V_{déclenchement}) de commande de tension d'élévation et des second moyens (57ac) de transfert de potentiel pour transférer un potentiel de la tension de source d'alimentation en fonction du potentiel de charge de ce condensateur.

17. Dispositif de mémoire à semi-conducteur selon l'une quelconque des revendications 15 ou 16, dans lequel les moyens (57b) de fourniture de tension d'alimentation ont des premiers moyens (57bb) de transfert de potentiel qui sont commandés par le premier signal (V_{TO}) de commande de tension d'élévation en fonction de signaux internes et d'un signal sélectionné parmi les signaux de cadencement, et un condensateur (C₇) d'élévation de tension qui commence l'opération d'élévation de tension lorsqu'il reçoit le second signal (V_{déclenchement}) de commande de tension d'élévation, et des second moyens (57bc) de transfert de potentiel pour transférer la tension d'élévation en fonction du potentiel de charge du condensateur précité.

18. Dispositif de mémoire à semi-conducteur selon l'une quelconque des revendications 15 à 17, dans lequel la partie (57a) de fourniture de tension de source d'alimentation a des moyens (57ad) de limitation qui limitent un accroissement de tension produit par l'opération d'élévation de tension.

19. Dispositif de mémoire à semi-conducteur selon l'une quelconque des revendications 10 à 18, dans lequel les moyens de commande d'application de potentiel de ligne de mots comportent des premiers moyens de transfert de potentiel qui transfèrent un potentiel sélectionné d'un décodeur de ligne et des moyens (22) à mémoire tampon de ligne de mots sous la commande du second signal (V_{déclenchement}) de commande d'élévation de tension à un condensateur d'élévation (C₈, C₉) qui commence l'opération d'élévation de tension, et des second moyens (59b) de transfert de potentiel qui fournissent la tension d'alimentation de ligne de mots à la ligne de mots sous la commande de la tension d'élévation.

20. Dispositif de mémoire à semi-conducteur selon la revendication 19, dans lequel les moyens (59) de commande d'application de potentiel de ligne de mots ont des moyens (59c) de cadencement de décharge qui génèrent un signal (t_{RO}) de cadencement de décharge lorsqu'il reçoit des signaux internes et des signaux sélectionnés parmi les signaux de cadencement, et des moyens (59d) de décharge qui déchargent le condensateur (C₈, C₉) d'élévation de tension en fonction de ce signal de cadencement de décharge.

21. Dispositif de mémoire à semi-conducteur selon la revendication 19 ou 20, dans lequel les moyens (59) de commande d'application de potentiel de ligne de mots ont des moyens (59e) de décharge de ligne de mots qui déchargent la charge de la ligne de mots en fonction d'un potentiel représentant une condition de non sélection par le décodeur de ligne et les moyens (22) à mémoire tampon de ligne de mots.

22. Dispositif de mémoire à semi-conducteur selon l'une quelconque des revendications 7 à 21, dans lequel une électrode de chacun des condensateurs d'élévation est formée par une première couche semi-conductrice et les autres électrodes de chacun des condensateurs sont formées par une seconde couche semi-conductrice disposée par l'intermédiaire d'une couche isolante sur la première couche semi-conductrice.

23. Dispositif de mémoire à semi-conducteur selon la revendication 22, dans lequel l'électrode négative de chacun des condensateurs d'élévation est formée par la seconde couche semi-conductrice, et l'électrode positive de chacun des condensateurs est formée par la première couche semi-conductrice.

24. Dispositif de mémoire à semi-conducteur selon l'une quelconque des revendications 1 à 23, dans lequel les premier et second moyens (HR2, HR1) formant charge sont des éléments formant charge du type à résistance élevée.

25. Dispositif de mémoire à semi-conducteur selon la revendication 24, dans lequel les éléments formant charge du type à résistance élevée sont constitués d'un polysilicium à résistance élevée.

26. Dispositif de mémoire à semi-conducteur selon la revendication 24, dans lequel les éléments formant charge du type à résistance élevée sont des éléments MOS du type charge.

27. Dispositif de mémoire à semi-conducteur selon l'une quelconque des revendications précédentes, dans lequel les moyens (50) de transformation de tension de ligne de mots comportent des moyens (59) de commande d'application de potentiel pour appliquer le potentiel d'écriture à la ligne de mots lorsque l'opération d'écriture est sélectionnée et pour appliquer une tension inférieure à cette tension d'écriture à la ligne de mots lorsque l'opération de lecture de données est sélectionnée.

28. Dispositif de mémoire à semi-conducteur selon la revendication 27, comprenant en outre des moyens (39) de détection de potentiel appliqué qui détectent un point où le potentiel de la ligne de mots est fixé à un pour l'opération de lecture de données, et des moyens (38) de commande d'amplificateur de détection qui génèrent un signal de commande d'amplificateur de détection pour activer des moyens amplificateurs de détection en fonction de la sortie des moyens de détection de potentiel appliqué.

29. Dispositif de traitement de données ayant un dispositif à mémoire selon l'une quelconque des revendications précédentes, pour stocker des données, des moyens d'exécution d'opérations logiques qui exécutent des opérations logiques sur des données, et des moyens d'entrée/sortie qui effectuent l'entrée ou la sortie des données.
